# EUROPEAN PATENT SPECIFICATION

(11) **EP 2 611 950 B1**
(45) Date of publication and mention of the grant of the patent: **13.11.2013**
(21) Application number: 11760829.9
(22) Date of filing: 08.07.2011
(51) Int. Cl.: C25D 3/38, C25D 5/00, C25D 21/02, C25D 7/12, C25D 17/00, H01L 21/768, H01L 21/288

(54) **PROCESS FOR ELECTRODEPOSITION OF COPPER CHIP TO CHIP CHIP TO WAFER AND WAFER TO WAFER INTERCONNECTS IN THROUGH-SILICON VIAS (TSV), WITH HEATED SUBSTRATE AND COOLED ELECTROLYTE**
VERFAHREN ZUR ELEKTROABSCHEIDUNG VON KUPFER VERBINDUNGEN, CHIP ZU CHIP, CHIP ZU WAFER UND WAFER ZU WAFER IN TSVS (THROUGH-SILICON-VIAS), MIT ERHITZTEM SUBSTRAT UND GEKÜHLTEM ELEKTROLYTEN.
PROCÉDÉ D'ÉLECTRODÉPOSITION D'INTERCONNEXIONS DE CUIVRE PUCE À PUCE, PUCE À TRANCHE ET TRANCHE À TRANCHE DANS DES TROUS D'INTERCONNEXIONS À TRAVERS LE SILICIUM (TSV), AVEC UN SUBSTRAT CHAUFFÉ ET UN ÉLECTROLYTE REFROIDI

(30) Priority: 29.07.2010 US 845801
(43) Date of publication of application: 10.07.2013
(73) Proprietor: Atotech Deutschland GmbH, 10553 Berlin (DE)
(72) Inventor: PREISSER, Robert, F., 72119 Ammerbuch (DE)
(74) Representative: Wonnemann, Jörg
(86) International application number: PCT/IB2011/001598
(87) International publication number: WO 2012/014029

(56) References cited:
- WO-A1-2010/094998
- US-A1- 2005 224 359
- US-B1- 6 793 795

## Description

### BACKGROUND

### 1. Field of the Invention

The invention relates to a process of electrolytically forming conductor structures from highly pure copper, more specifically to electrolytically forming conductor structures from highly pure copper in through-silicon vias (TSVs) when producing devices such as MEMS or semiconductor devices. Such TSVs are useful, e.g., in integrated circuits, in a stacked or 3D arrangement, in which the TSV provide electrical connection between the respective layers of the device, where the TSV have relatively large diameter, relatively great depth and a high aspect ratio. The electrolytic formation of conductor structures is enhanced and improved by application of heat to the substrate while maintaining the electrolytic bath at a lower temperature.

### 2. Description of Related Art

The demands of fabricating cheaper, smaller and lighter electronic products offering better performance and increased functionality are continuously growing. The number of electronic device on a single chip is still rapidly increasing, and the ability of 2D layouts to accommodate these demands is being exceeded. According to industry roadmaps, integrated circuit (IC) chip size will be on the order of 30 nm by 2010. Such a small chip must carry more than 100 million transistors, which will require more than 100,000 I/Os for the next level packaging. As a result, chip and MEMS designers have turned to multilevel interconnection, which has been referred to as three-dimensional (3-D) stacking. 3-D wafer stacking represents a wafer level packaging technique in which specific components, such as logic, memory, sensors, A/D converters, controllers, etc., are fabricated on separate wafer platforms and then integrated onto a single wafer-scale or chip-scale package using Through-Silicon Vias (TSVs) to provide electrical interconnection between elements of the 3-D stack. Because these devices are interconnected in the vertical axis, the electrical signal path between components becomes shorter, which results in lower parasitic losses, lower power consumption, and better system performance. Fabrication of TSVs by electrodeposition and other techniques has been reported. Although several conductive materials such as gold, polysilicon, tin and tin-lead (Sn-Pb) solder have been used as interconnect material, copper is the best and most preferred choice due to its higher electrical conductivity and electromigration resistance. For the purpose of depositing metal in deep through-holes, e.g., TSVs, electroplating is the most widely used process.

TSVs have been used for forming electrical connections between respective layers in a stacked or 3D arrangement in devices such as MEMS and semiconductor devices, but have suffered from various defects arising, at least partially, from difficulty in electroplating highly pure copper into the very large, high aspect ratio vias in the TSVs. For example, a typical TSV has an inner diameter in the range from about 1 to about 10 microns (although greater diameter TSVs may also be used), and a depth ranging from about 5 microns to about 450 microns or even greater depths (although depths of 5 to 25 microns, or of 100 microns, are more common in some applications). Future inner diameters are expected to be, for example, about 1 micron. The aspect ratio (depth/width) of the typical TSV is greater than 3:1 and usually about 5:1 or greater. At present, in some TSVs, the aspect ratio may be about 10:1, and the aspect ratio may be as high as 50:1. Future aspect ratios are expected to be commonly from about 10:1 to about 20:1, and for MEMS structures, eventually as high as 100:1 or greater. Attempts to electrodeposit high purity copper into such high aspect ratio TSVs have been partially successful, but have been plagued with problems arising from (a) internal stresses in the copper deposit which can result in wafer bending or deformation upon subsequent heating, (b) non-uniform deposits (i.e., grain boundaries, crystal structure defects, etc.), (c) inclusions of gases (voids) and/or electroplating bath liquid in the body of the electrodeposited copper, which can result in wafer bending, and (d) excess metal deposition at the inlet and outlet of the TSV through-hole.

Of these problems, the internal stress problem (a) can be the most troublesome, since this defect may result in bending and deformation of the silicon substrate through which the TSV is formed, and this can cause failure of the entire 3D arrangement. This failure may not occur until after the entire device has been fabricated, resulting in loss of not only the failed silicon substrate, but of the whole device into which the silicon substrate has been incorporated at the time of failure.

An overarching, long-standing problem in semiconductor manufacture is the time required to carry out the multitude of processing steps required to produce modern semiconductor devices which, if excessive, can adversely affect the overall economics of device manufacture. In conventional processes for forming TSVs by electrodeposition, due to the requirement for highly pure and internal stress-free TSV fill material, the rate of electrodeposition has been significantly slow. When a deposit of metal in the range of 5 to 50 microns in thickness is required to be electrodeposited on thousands of wafers per day, a deposition rate of less than 1 micron per minute may be unacceptably slow. While increasing electrodeposition bath temperature can enhance the deposition rate, it also increases the rate of decomposition of organic compounds added to the bath. Accordingly, there is a need to improve the rate of electrodeposition of such metals for TSV filling and to reduce the rate of decomposition of organic bath components.

Document US 2005/224359 discloses an apparatus and a method for metal electroplating. The apparatus includes an electroplating tank for containing an electrolyte at a first temperature, a substrate holder and a heater for heating the portion of the electrolyte adjacent to the substrate holder to a second temperature higher than the first temperature (at least 5°C), the second temperature (of or at the substrate) being comprised between 27 and 80°C. This document however fails to disclose the use of a cooling unit to maintain the lower temperature of the electrolyte.

### SUMMARY

In various of its embodiments, the present invention avoids the disadvantages of known processes and, more particularly, maximizes the rate of electrodepositing the metal fill of the TSVs with a metal such as highly pure copper while at the same time the invention minimizes stress, avoids defects such as inclusions and voids, and other defects which have been found in prior art TSVs, and avoids undue decomposition of organic bath components. The present invention thus addresses the problem of improving the rate of electrodeposition of metals for TSV filling while reducing the rate of decomposition of organic bath components.

The invention in some embodiments relates to a process of electrolytically forming conductor structures from highly pure copper in through-silicon vias (TSVs), including the TSV-connection of redistribution wirings, and MEMS structures formed in silicon substrates such as silicon wafers used, e.g., in semiconductor devices and MEMS devices. While recognizing that these are somewhat different structures, these conductor structures are collectively referred to as TSVs, for convenience and to avoid prolix. The process according to one embodiment of the present invention may be summarized as follows:

A process of electrodepositing a metal in a via in a silicon substrate to form a through-silicon-via (TSV), comprising:
providing a silicon substrate containing at least one via, wherein the via includes an inner surface having an internal width dimension in the range from about 1 micron to about 30 microns and greater, a depth from about 5 microns to about 450 microns and a depth:width aspect ratio of at least 3:1, and the via further includes a basic metal layer covering of the inner surface with a sufficient thickness of basic metal to obtain sufficient conductance for subsequent electrodeposition of the metal;
providing an electrolytic bath in an electrolytic metal plating system with the basic metal layer connected as a cathode,
the system further comprising
a chuck adapted to hold the silicon substrate and to heat the silicon substrate uniformly to a first temperature,
a temperature control device to maintain temperature of the electrolytic bath at a second temperature, wherein the temperature control device comprises a cooling unit,
an insoluble (inert) dimensionally stable anode and a metallic source of the metal, wherein the electrolytic bath comprises an acid, a source of ions of the metal, a source of ferrous and/or ferric ions, and at least one additive for controlling physical-mechanical properties of deposited metal; and
applying an electrical voltage between the insoluble dimensionally stable anode and the basic metal layer, so that a current flows therebetween through the bath for a time sufficient to electrodeposit the metal on the basic metal layer to form a TSV, wherein a Fe⁺²/Fe⁺³ redox system is established in the bath to provide additional ions of the metal to be electrodeposited by dissolving ions of the metal from the metallic source and wherein the first temperature is maintained in a range from about 30°C to about 60°C and the second temperature is maintained by the cooling unit at a temperature (a) at least 5°C lower than the first temperature and (b) in a range from about 15°C to about 35°C. In one embodiment, the second temperature is 20°C ± 2°C. In one embodiment, the first temperature is from about 35°C to about 55°C. In one embodiment, the second temperature is 20°C ± 2°C, while the first temperature is from about 35°C to about 55°C.

In one embodiment, the electrodeposited metal is copper, and in one embodiment, high purity copper.

In one embodiment, one or more of the at least one additive undergoes substantial decomposition in the electrolytic bath at the first temperature but does not substantially decompose at the second temperature. In one embodiment, the second temperature is selected based on temperature at which decomposition of one or more of the at least one additive would become substantial in the electrolytic bath.

In one embodiment, the rate of electroplating at the first temperature is substantially greater than the rate would be at the second temperature.

In one embodiment, the inner surface is covered with a barrier layer and the barrier layer is covered by a basic metal layer. A liner layer may be between the barrier layer and the basic metal layer, to improve compatibility of those layers. Various materials are suitable for this liner layer, including tantalum when the barrier layer is tantalum nitride. In one embodiment, the inner surface is covered with a barrier layer of a material such as tantalum nitride, which is in turn covered by a liner layer of tantalum and the liner layer is covered by a basic metal layer. In one embodiment, the inner surface is covered with a layer of tantalum nitride, the tantalum layer is covered by a layer of tantalum nitride as the barrier layer, and the basic metal layer is copper and covers the barrier layer.

In one embodiment, the inner surface is covered with a layer of a dielectric material and the basic metal layer covers the layer of a dielectric material. In one embodiment, the inner surface is covered with a layer of a dielectric material, which layer of dielectric material is covered by a barrier layer, and the barrier layer is covered by the basic metal layer. As in the embodiments above, a liner layer may be between the barrier layer and the basic metal layer. In one embodiment, the inner surface is covered by a dielectric, such as silicon dioxide, and the dielectric layer is covered by a layer of tantalum nitride, and the tantalum nitride layer is covered by a layer of tantalum, and the tantalum is covered by the basic metal layer, and the basic metal layer comprises copper. The basic metal layer may be another metal, for example ruthenium. In one embodiment, when ruthenium is used for the basic metal layer, and the barrier layer is tantalum nitride, it is not necessary to include a liner layer.

In one embodiment, the dielectric layer comprises silicon dioxide, and in other embodiments, may comprise other known low-K materials. Known low-K materials include, for example, fluorine-doped silicon dioxide, carbon-doped silicon dioxide, porous silicon dioxide, porous carbon-doped silicon dioxide, spin-on organic polymeric dielectrics, such as SiLK, polyimide, polynorbornenes, benzocyclobutene, PTFE, porous SiLK and spin-on silicone based polymeric dielectric.

In one embodiment, the barrier layer comprises tantalum and in one embodiment, a combination of tantalum over tantalum nitride. In one embodiment, the dielectric layer comprises silicon dioxide and the barrier layer comprises tantalum nitride. In one embodiment, the dielectric layer comprises silicon dioxide and the barrier layer comprises a combination of tantalum over tantalum nitride. Other barrier materials may be used, such as TiN, TiN/Ti, Ta, TaNₓ, WNₓ, TiSiₓN_{y}, WSiₓN_{y}, WBₓN_{y}, each of which may be combined with silicon dioxide or other known low-K materials as the dielectric layer.

In one embodiment, the basic metal layer is formed over the barrier layer by one or more of a physical deposition process, a chemical vapor deposition process, or a plasma-enhanced chemical vapor deposition process.

In one embodiment, the applying is effective to electrodeposit the metal to completely fill the via. In one embodiment, the applying is effective to electrodeposit the metal, e.g., high purity copper, to completely fill the via, with no voids and no defects that inhibit its function in the finished device.

In one embodiment, the deposited metal, e.g., high purity copper, is either substantially free of internal stress or includes a level of internal stress that does not result in bending of the silicon substrate upon subsequent processing.

In one embodiment, the deposited metal, e.g., high purity copper, is substantially free of voids and non-metal, e.g., non-copper, inclusions.

While the thickness may be determined as appropriate by the skilled person, in one embodiment, the basic metal layer has a thickness in the range from about 0.02 *µ*m to about 0.5 *µ*m.

In one embodiment, the basic metal layer comprises copper.

In one embodiment, the barrier layer is a material which, in addition to functioning as a barrier layer, also is a dielectric material. In one embodiment, this material is tantalum nitride, TaN.

In one embodiment, in the electrolytic bath, the acid is sulfuric acid at a concentration in the range from about 50 to about 350 g/l, the source of ions of the metal is copper sulfate pentahydrate at a concentration in the range from about 20 to about 250 g/l, the source of ferrous and/or ferric ions is ferrous sulfate heptahydrate and/or ferric sulfate nonahydrate at a concentration in the range from about 1 to about 120 g/l, and the at least one additive comprises one or more of a polymeric oxygen-containing compound, an organic sulfur compound, a thiourea compound and a polymeric phenazonium compound.

In one embodiment, the electrical voltage is applied in a pulse current or a pulse voltage. In one embodiment, the electrical voltage is applied as ramped DC voltage.

In one embodiment, the electrical voltage is applied in a reverse pulse form with bipolar pulses.

As described in summary in the foregoing, and in detail in the following, in various of its embodiments, the present invention avoids the disadvantages of known processes and, more particularly, maximizes the rate of electrodepositing the metal fill of the TSVs with a metal such as highly pure copper while at the same time the invention minimizes stress, avoids defects such as inclusions and voids, and other defects, which have been found in prior art TSVs. The present invention therefore addresses and provides a solution to the problem of improving the rate of electrodeposition of metals for TSV filling, while at the same time not compromising on the thermal stability of organic compounds used as bath additives. The elevated temperature enhances the mobility of the copper ions so the deposition rate is increased, while at the same time obtaining equal or better quality deposited copper and equal or better performance of the deposited copper, and maintaining the electrolytic bath at a lower temperature prevents enhanced thermal degradation of the organic additives that improve the quality of the deposit, which degradation would otherwise occur due to resultant elevated temperature of the bath.

### BRIEF DESCRIPTION OF THE DRAWINGS

**FIG. 1** is a schematic plan view of a conventional chip architecture.
**FIG. 2** is a schematic cross-sectional view of a TSV-enabled stacked chip architecture, which can be obtained by a manufacturing process including a process in accordance with embodiments of the present invention.
**FIG. 3** is a schematic cross-sectional view of an electroplating device for use in accordance with an embodiment of the present invention.
**FIGS. 4-7** are polarographic curves for copper plating to fill TSVs in accordance with embodiments of the present invention and in accordance with embodiments outside the present invention.
**FIG. 8** is a schematic cross-sectional view of a 3D device including a substrate having mounted thereon two wafers including copper-filled TSVs electrodeposited by a process according to an embodiment of the present invention.
**FIGS. 9-16** are schematic cross-sectional views of steps in a process of forming TSVs in a wafer and mounting the wafer onto a substrate to form part of a 3D device such as that shown in **FIGS. 2** and **8** in accordance with an embodiment of the present invention.

It should be appreciated that for simplicity and clarity of illustration, elements shown in the Figures have not necessarily been drawn to scale. For example, the dimensions of some of the elements may be exaggerated relative to each other for clarity. Further, where appropriate, reference numerals have been repeated among the Figures to indicate corresponding elements.

Furthermore, it should be appreciated that the process steps and structures described below do not form a complete process flow for manufacturing parts such as fasteners described herein. The present invention can be practiced in conjunction with fabrication techniques currently used in the art, and only so much of the commonly practiced process steps are included as are necessary for an understanding of the present invention.

### DETAILED DESCRIPTION

As used herein, the term "high purity copper", in reference to the copper electrodeposited in accordance with the present invention, refers to copper having a purity of at least 99%, as determined by standard chemical/instrumental analytical methods. In one embodiment, ICP-MS (inductively coupled plasma mass spectrometry) is used for analysis of the copper raw material. As will be understood, the purity of the copper deposit is primarily determined by the purity of the copper raw material, in addition to the herein disclosed process and system.

As used herein, the term "physical-mechanical properties", when applied to an electrodeposited metal layer in accordance with the present invention, refers to one or more of brightness, ductility, grain size, hardness, resistivity, contact resistance and reliability performance.

In one embodiment, the overall process of the invention includes steps of forming vias in the substrate, e.g., by RIE, sputtering tantalum nitride to form a barrier layer on the sidewalls of the vias, sputtering tantalum over the tantalum nitride to form a liner, sputtering a copper seed layer over the liner layer, electrodepositing copper to fill the vias and thereby form the TSV, in which in the electrodepositing step, the heated chuck and cooled electrolytic bath as described herein are employed, and annealing the electrodeposited copper. As will be readily recognized, the foregoing reflects important steps, but not the only steps, in the overall process.

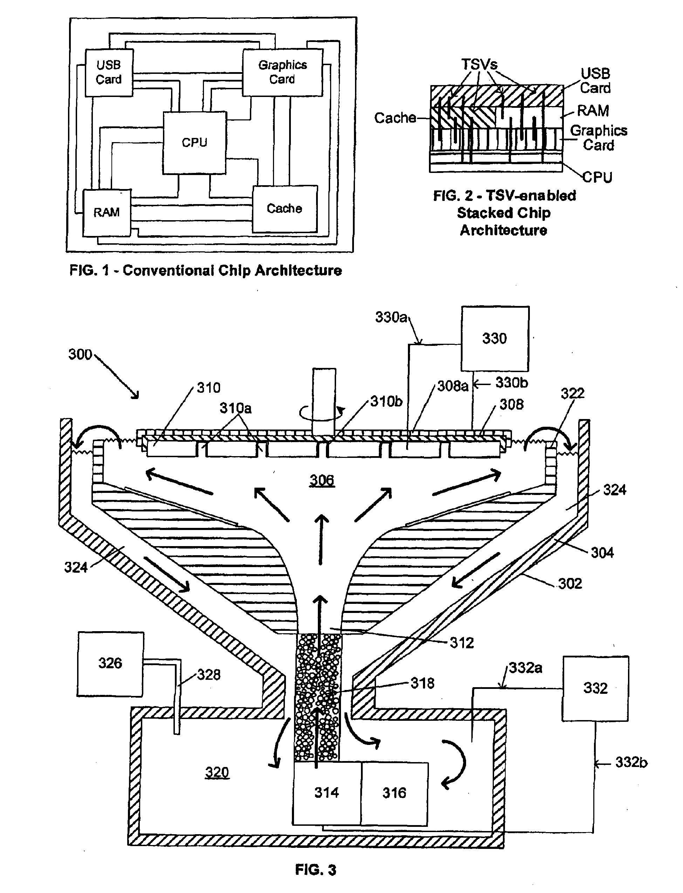

**FIG. 1** is a schematic plan view of a conventional chip architecture. As shown in FIG. 1, in a conventional chip architecture, the various components are arrayed in a substantially planar arrangement, with components, such as the exemplary USB card, RAM, graphics card and cache, arrayed around a CPU chip substantially in the same plane. As a result, e.g., of further miniaturization of devices and components, and of the ever-increasing number of transistors, and of the need for ever-shorter timings of signal transmittance, this conventional chip architecture has become problematical, in that it simply takes up too much space in the limited areas available in the ever-smaller devices and the distances between components can become limiting of the overall speed of the device.

**FIG. 2** is a schematic cross-sectional view of a TSV-enabled stacked chip architecture, which can be obtained by a manufacturing process including a process in accordance with embodiments of the present invention. In the stacked chip architecture, the components are stacked vertically, in a 3D arrangement, and are interconnected by TSVs. Without the TSVs, it would be difficult or impossible to build a device in three dimensions such as the exemplary arrangement in FIG. 2. The stacked chip architecture takes up considerably less area and moves the components into much closer proximity to each other, thereby allowing for smaller devices and shorter signal transmittance times. With TSVs obtained by a process including use of embodiments of the present invention, such as shown in FIG. 2, the problems of reducing size and increasing signal speed can be addressed.

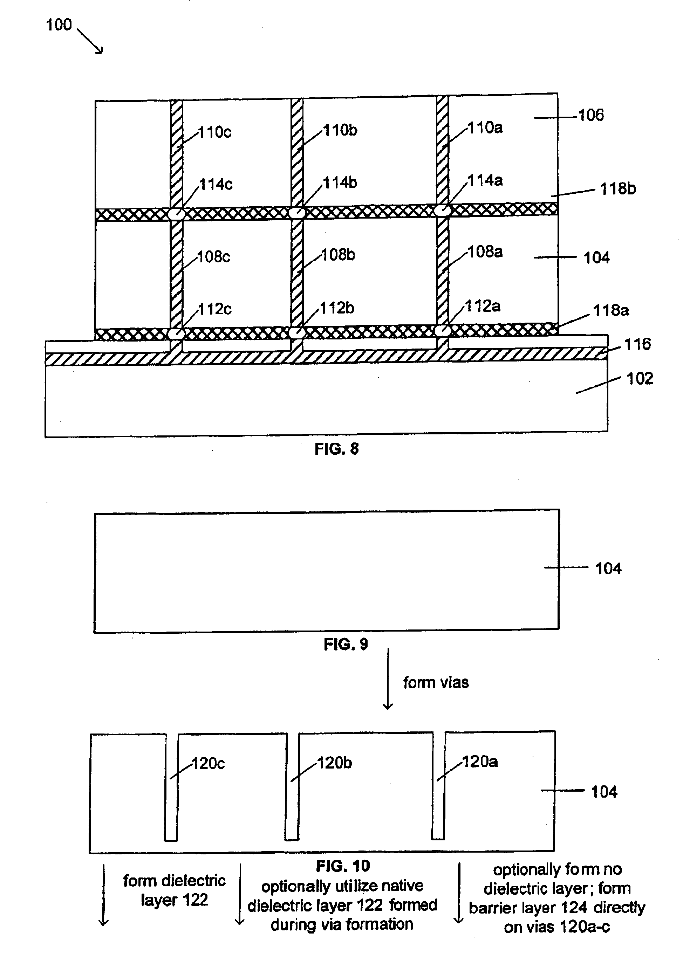

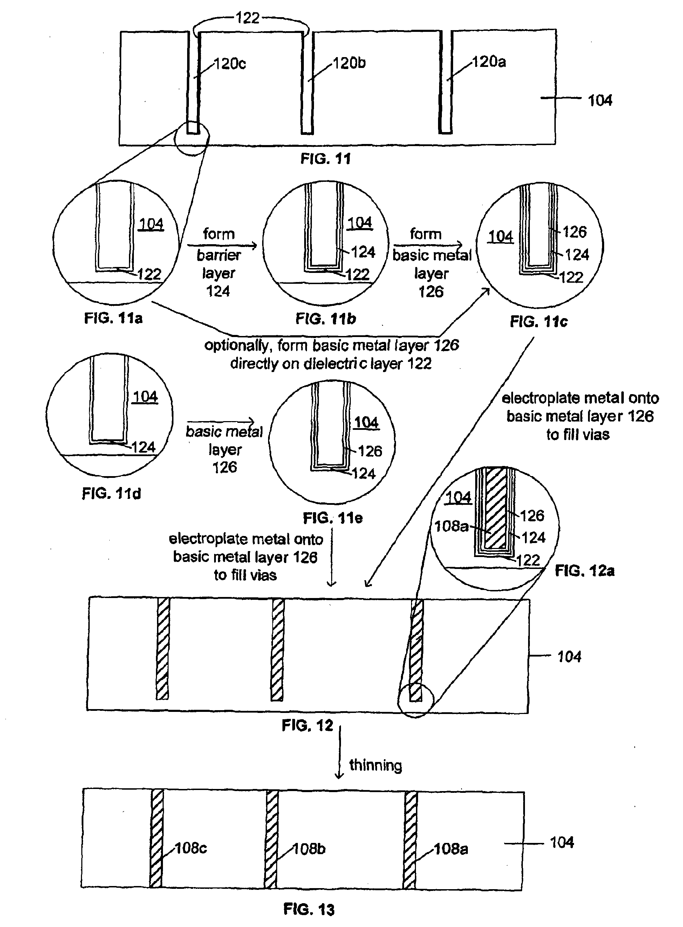

In another embodiment, as shown in **FIGS. 10****,** **11d** and 11e, subsequent to formation of the TSVs 120a-120c, in the next step of a process according to an embodiment of the present invention, no dielectric layer is formed, and a barrier layer 124 is formed directly on the inside surface of the sidewalls of each TSV 120, as shown in FIG. **11d****,** as described in the following, except that there is no dielectric layer separately formed. In this case, the substrate 104 in **FIG. 11** would have the TSVs 120 with no layer 122, and the other layers (barrier, basic metal and electrodeposited metal) would be formed as described below but without a dielectric layer on the TSV wall under the layers.

### FORMATION OF TSVs

Formation of vias with smooth sidewalls in the silicon substrate is an important step in the fabrication of a 3D device employing TSVs. In accordance with the present invention, any known method of forming vias may be used, and the via may be formed at any appropriate time during the fabrication process. The process used in formation, and the size of the vias are not limited in the present invention.

### FILLING TSVs BY ELECTRODEPOSITION

Complete, void-free and inclusion-free filling of TSVs with metal such as high purity copper is a very important step in the manufacture of devices incorporating TSVs. Incomplete metal filling, e.g., filling that includes voids or inclusions, in the TSVs can lead to short-circuiting or poor conduction and will affect the electrical performance of the overall device. Grain size of the deposited copper is very important, since grain roughness can directly affect the electrical properties such as electrical resistivity, electromigration resistance, and internal stress in the TSV. As noted herein, internal stress in the TSV can result in severe problems if it causes bending or deformation of the wafer or silicon substrate through which the TSV is located. The stress can result from, e.g., rough grains or other defects, and the resulting deformation or bending can cause mechanical failure of the overall device. Thus, obtaining smooth, void-free, inclusion-free, fine grain metal deposition in the high aspect ratio TSVs is essential. The present invention provides such deposits of high purity copper.

Thus, according to the invention, a process of producing a highly pure copper fill in through-silicon vias (TSVs) formed, e.g., through semiconductor substrates (wafers), is provided and may be carried out in combination with conventionally known processes of semiconductor device manufacturing.

In order to obtain increased electrodeposition rate, the substrate, including the cathodic via walls to be electroplated, can be heated to increase the rate of deposition. However, heating the substrate will result in temperature increase in the electroplating bath composition, and this temperature increase can result in rapid decomposition of bath additive(s). The bath additive(s) are needed to obtain the optimum quality of electrodeposit in the TSVs, and any loss can be problematical. If the additive losses are not compensated, then the quality of the electrodeposit in the TSVs will suffer. If the losses can be compensated but are too extensive, then the costs of the process will increase and may become non-economical.

In order to obtain a significantly improved combination of electrodeposition quality and rate, in accordance with the present invention, the substrate is heated and the electroplating bath composition is cooled or otherwise maintained at a temperature lower than that to which the substrate is heated during the process. As a result of the bath being maintained at a lower temperature, the additive(s) in the electroplating bath composition are stabilized, only the portion of the electroplating bath composition adjacent to the substrate is heated, and the temperature of the heated portion is relatively quickly reduced following contact with the heated substrate. As a result of the heating, the rate of electrodeposition in the vias to form TSVs is substantially increased while quality of the electrodeposition is maintained due to the presence of the additive(s). In accordance with the present invention, this advantage is attained while the disadvantage of temperature-induced additive decomposition is avoided.

The present inventors have discovered that best results are obtained when the substrate temperature is maintained in a range from about 30°C to about 60°C, and in one embodiment from about 40°C to about 60°C. The higher the temperature, the faster the electrodeposition will take place, so one would want to increase the substrate temperature as much as possible. However, this higher substrate temperature can have the above-noted negative effect on the bath additive(s). Accordingly, the present inventors have determined that excellent results can be obtained when the bath temperature is maintained at a temperature (a) at least 5°C lower than the substrate temperature and (b) in a range from about 15°C to about 35°C, and in one embodiment from about 15°C to about 30°C, and in one embodiment, at a temperature of about 20°C. The lower the bath temperature, the less degradation of the additives is observed. However, this can have the above-noted negative effect on electrodeposition rate. Therefore, the balance lies between these temperatures. As will be understood, consideration must be given to factors specific to each system, including consideration of the identity of the metal to be deposited (e.g., high purity copper), the nature of the additives, the nature of the substrate, the presence of the optional dielectric and/or barrier layers, and the electrodeposited metal quality required for a given application. Some or all of these factors may be of greater or lesser importance in a given case, but generally all need to be taken into account. Having done so, the inventors consider that the temperatures noted above are adequate to obtain the goals of the present invention, when used as described herein. As noted, it is very important for the function of TSVs for the electroplating to deposit the best possible fill material for the TSVs, and the present invention provides an unexpectedly efficacious means to that end.

The process, according to one embodiment of the invention, provides for electrodepositing high purity copper in a via in a silicon substrate to form a through-silicon-via (TSV), including the following steps (1)-(6), (noting that steps (2) and (3) are optional, as described below):
(1) providing a silicon substrate containing at least one via, wherein the via includes an inner surface having an internal width dimension in the range from about 1 micron to about 30 microns and greater, a depth from about 5 microns to about 450 microns and a depth:width aspect ratio of at least 3:1, and the via further includes a basic metal layer covering of the inner surface with a thickness of basic metal to obtain sufficient conductance for subsequent electrodeposition of the metal;
(2) optionally, forming a dielectric layer on the inner surface of the via;
(3) optionally, forming a barrier layer over the dielectric layer when present, or over the inner surface of the via, wherein the barrier layer is or comprises a material which inhibits diffusion of copper into the silicon substrate, including, if needed, forming a liner layer over the preceding layer(s) to enhance compatibility with the subsequently formed basic metal layer;
(4) forming a basic metal layer on the inner surfaces of the TSV, over any preceding layer(s);
(5) providing an electrolytic bath in an electrolytic metal plating system with the basic metal layer connected as a cathode,
   the system further comprising
   a chuck adapted to hold the silicon substrate and to heat the silicon substrate uniformly to a first temperature,
   a temperature control device to maintain temperature of the electrolytic bath at a second temperature,
   an insoluble dimensionally stable anode and a metallic source of the metal, wherein the electrolytic bath comprises an acid, a source of ions of the metal, a source of ferrous and/or ferric ions, and at least one additive for controlling physical-mechanical properties of deposited metal; and
(6) applying an electrical voltage between the insoluble dimensionally stable anode and the basic metal layer, so that a current flows therebetween through the bath for a time sufficient to electrodeposit the metal on the basic metal layer to form a TSV, wherein a Fe⁺²/Fe⁺³ redox system (sometimes referred to as a mediator) is established in the bath to provide additional ions of the metal to be electrodeposited by dissolving ions of the metal from the metallic source and wherein the first temperature is maintained in a range from about 30°C to about 60°C and the second temperature is maintained at a temperature (a) at least 5°C lower than the first temperature and (b) in a range from about 15°C to about 35°C. In one embodiment, the second temperature is 20°C ± 2°C. In one embodiment, the first temperature is from about 35°C to about 55°C. In one embodiment, the second temperature is 20°C ± 2°C, when the first temperature is from about 35°C to about 55°C. In one embodiment, the second temperature is 20°C ± 2°C when the first temperature is from about 40 °C to about 45 °C. When this process is carried out, particularly using copper as the metal, TSVs are obtained that have very good characteristics and the process efficiently operates with minimal loss of the additive(s).

FIG. 3 is a schematic cross-sectional view of an electroplating device 300 for use in accordance with an embodiment of the above-described process of the present invention. The schematic depiction of the device 300 includes an exemplary arrangement of components of an apparatus suitable for carrying out the method described above. As will be recognized, other arrangements of such a device can be constructed, and are expected to function in substantially the same manner as described herein. Thus, the present invention is not limited to the device described herein, but the process may be carried out in any suitable device known in the art, so long as it allows for the specified temperature control, and other features of the invention.

FIG. 3 shows an embodiment of the electroplating device 300, which can be further modified by those skilled in the art and is not limited to the specific electroplating apparatus 300 in FIG. 3. The electroplating device 300 includes a plating tank 302, one or more insoluble, dimensionally stable anode 304, an electrolyte 306, a substrate chuck 308 for holding a semiconductor substrate 310, an electrolyte inlet 312, a cooling unit 314, a circulation pump 316, and a source of metal 318. The chuck 308 is adapted both to hold the substrate 310 and to heat the substrate 310 uniformly to a first, selected temperature, greater than the temperature of the electrolyte 306. The chuck 308 is equipped with appropriate gripping mechanisms known in the art for gripping, holding and supporting the substrate 310 on the lower surface of the chuck. The chuck 308 further includes a heating element 308a. The substrate 310 includes vias 310a and a basic metal layer 310b (not to scale). The cooling unit 314 and the circulation pump 316 may be conveniently contained in an electrolyte reservoir 320, or may be situated outside and operatively connected to the device 300 through appropriate piping. The electrolyte 306 in the reservoir 320 is taken up by the pump 316, pumped through the cooling unit 314 and through the source of metal 318. The order in which the electrolyte 306 is pumped, cooled and contacted with the source of metal may be revised in any order, as will be understood by the skilled person, taking into consideration factors such as actual temperature of the electrolyte 306, relative reactivity of the metal with the Fe⁺³/Fe⁺² redox system, and solubility of the metal ions in the electrolyte. The source of metal 318 may include particles such as pellets, balls, beads, bars, etc., of the metal to be electrodeposited, and is the source of replenishment metal ions for the electrolyte 306. As discussed herein, in the Fe⁺³ / Fe⁺² redox system of the present invention, metal is dissolved from the particles into the electrolyte 306 by the Fe⁺³ ions in the circulating electrolyte. The Fe⁺³ ions are reduced to Fe⁺² while the metal is oxidized, e.g., Cu⁰ is oxidized to Cu⁺² ions. The electrolyte 306 flows from the electrolyte inlet 312 into the plating tank 302, upward over the substrate 310 and into the vias 310a, and the metal is electroplated onto the basic metal layer 310b on the substrate 310 and in the vias 310a. Excess electrolyte 312 overflows a weir 322 and into a trough 324 through which it returns to the electrolyte reservoir 320, as shown in FIG. 3, and/or into appropriate piping to the cooling unit 314 and the recirculation pump 316. Additional or replenishment chemicals and solution make-up may be introduced into the system, for example, from a make-up reservoir 326 into the electrolyte reservoir 320 through appropriate piping 328. Although shown in FIG. 3 as a single make-up reservoir 326 and piping 328, as will be understood, multiple such apparatus may be employed as needed.

With the semiconductor substrate 310 at an upper part of the plating tank 302, the semiconductor substrate 310 can be easily moved in and out of the plating tank 302. The chuck 308 includes the heating element 308a disposed on (as shown) or contained within (not shown) the chuck, to generate and conduct heat to the substrate 310. The heating element can be a heat exchange pipe containing thermal oil capable of heat exchange, or any other suitable heating element such as an electrothermal coil. In one embodiment, the chuck 308 is capable of both heating and cooling the substrate 310. In one embodiment, the chuck 308 is capable only of heating the substrate 310, but not cooling it. As indicated by the arrow, the device 300 may also include a device such as an electric motor (not shown) for rotating the substrate 310 in the electrolyte 306. Any suitable device may be used for rotation, such as a direct electric motor, a gear- or belt-driven motor, a fluid-driven device, and known equivalents of such rotation devices.

As shown in **FIG. 3****,** a temperature sensor and controller 330 is provided. The temperature sensor and controller 330 includes one or more temperature sensors 330a to determine the temperature of the substrate 310, and a temperature controller 330b to control operation of the heating element 308a in heating the substrate 310 to an appropriate, pre-selected first temperature.

The cooling unit 314 may be any appropriate device known in the art for controlling and reducing temperature of the circulating electrolyte 306. The device 300 includes a temperature control device 332 to detect, via a temperature detector 332a and to control, via a temperature controller 332b, the temperature of the circulating electrolyte 306. By use of this system, the device 300 is enabled to maintain the temperature of the electrolyte at a predetermined temperature, which, according to the invention, is lower than the temperature to which the substrate 310 is heated, as described above.

Although not shown, as will be understood, in addition to the bath and substrate temperature control apparatus described above, other appropriate control apparatus is included in the system 300; for example, flow sensors for the electrolyte and controllers for the substrate, the chuck, the electrolyte, etc., electrical connections and current controllers for the electrodeposition, speed controls for rotating the chuck, gas and bubble sensors, etc., all of which may be employed as known in the art. In addition, although depicted in FIG. 3 with the substrate oriented downwardly and the electrolyte flowing upwardly, this may be inverted, tilted, rotated or otherwise reoriented, and the present invention is not limited to operation in any particular orientation, except where experiment may so dictate or suggest.

As a result of the process, the metal is deposited on the basic metal layer 310b on the semiconductor substrate 310 and in particular in the vias 310a in the substrate 310, and the vias are completely and uniformly filled with the metal, e.g., high purity copper.

In one embodiment of the present invention, in the step (1) of the process, the silicon substrate is provided with vias already formed. Alternatively, the process may include formation of the vias, prior to transfer of the substrate to a tool or device including an electroplating device used to carry out a process in accordance with the present invention. As noted above, the vias may be formed by any appropriate method, and are most often formed by reactive ion etching. At the point in the process at which the silicon substrate is provided, there may be hundreds or even thousands of vias already formed. This of course depends on what point in the process of vias are to be filled, and on other factors that will be readily recognized, such as the type of substrate, the application for which the substrate is to be used, etc.

In general, the inner surface of the via either may be formed of the silicon of the silicon substrate or may be formed of a reaction product resulting from the reactive ion etching. Thus for example, where the reactive ion etching has been carried out with a halogen present such as fluoride, the inner surface of the via may contain or consist primarily or essentially of a silicon halide, such as silicon hexafluoride. Similarly, where the reactive ion etching has been carried out with oxygen present, the inner surface of the amount contain or consist primarily or essentially of silicon dioxide. Thus, in such an embodiment, it would not be necessary to include a step of forming or depositing a dielectric layer prior to proceeding with the subsequent steps of the process. If desired, of course, a separate or additional layer of a dielectric material may be formed by any suitable known method. As noted above, the dielectric layer is not necessary to the invention, but may be used when needed, as determined by the skilled person.

Since the TSVs will be filled with high purity copper in accordance with the present invention, suitable measures should be taken to prevent the diffusion of copper atoms into the silicon substrate situated adjacent to the TSVs. Thus, in one embodiment, a barrier layer is formed on the inner sidewalls of the TSV, in order to provide a barrier to diffusion of the later-deposited copper into the silicon of the substrate through which the TSV is formed. In one embodiment, the barrier layer is a tantalum-containing material capable of reducing and/or eliminating diffusion of copper therethrough. In one embodiment, the barrier layer is tantalum nitride. As noted, a liner layer may be formed over the barrier layer. The liner layer may be formed of tantalum when the barrier layer is tantalum nitride. The barrier layer and liner layer, if present, may be formed, for example, by a sputtering process. Suitable methods for formation of a layer of such barrier materials are known in the art and may be selected by the person of skill in the art as needed.

In order to permit the copper to be electrolytically deposited on the surface of the barrier layer, the barrier layer may be covered by an electrically conductive layer by deposition of a suitable basic metal layer over the barrier layer. In one embodiment, the basic metal layer is subsequently applied, which forms an electrically conductive base for the subsequent electrolytic metallization. In one embodiment, a full-surface layer having a thickness in the range from about 0.02 µm to about 0.3 µm, is applied as the basic metal layer. In one embodiment, the basic metal layer is applied by a physical metal deposition process and/or by a CVD process and/or by a PECVD process. In addition or alternatively, a plating process may also be used, for example an electroless metal deposition process. For example, a basic metal layer formed from copper may be deposited. Other conductive layers, usually metal layers, may also be suitable. Such conductive layers may include, for example, a metal such as tungsten, silver, gold, platinum, zinc, tin or any other metal or silicide known for use as a seed layer for electrodeposition of copper onto a non-conductive substrate.

In one embodiment, when a barrier layer is to be included, the barrier layer is formed of a material, such as silicon nitride or tantalum nitride, which functions both as a barrier as described, and as a dielectric. In this case, a separate dielectric layer can be omitted, and the step (2) above can be omitted. Of course, even when the barrier layer is or functions as a dielectric, it may be desirable to form a separate dielectric layer. As noted above, in some embodiments, depending on the method by which the vias are formed, the vias may be formed with a dielectric layer in place, and the dielectric layer is optional. As also noted above, the dielectric layer is optional, without regard to the other layers, depending on the substrate through which the via is formed. The nature of the other materials may also be considered in this regard.

In one embodiment, the basic metal layer is formed by one or more of an electroless plating process, a physical deposition process, a chemical vapor deposition process, or a plasma-enhanced chemical vapor deposition process. The basic metal layer is applied to the surface of the via in order to provide a suitable conductive surface for the electrodeposition of the high purity copper. Thus it is very desirable that the basic metal layer be applied in a manner such that it will completely cover the inner surface of the via.

The basic metal layer only needs to be thick enough to provide a conductive surface onto which the copper can be electrodeposited in the subsequent step. This thickness could be as low as a few nanometers, e.g., from about 1 nm to about 10 nm. However, in order to assure that a sufficient coverage has been obtained it may be desirable to apply a somewhat thicker layer of the basic metal. Thus, in one embodiment, the basic metal layer has a thickness in the range from about 0.01 micron to about 0.5 micron (i.e., about 10 nm to about 500 nm). In another embodiment, the basic metal layer has a thickness in the range from about 0.02 micron to about 0.25 micron, and in another embodiment the basic metal layer has a thickness in the range from about 0.05 micron to about 0.2 micron.

In one embodiment, the basic metal layer comprises copper. In another embodiment, the basic metal layer comprises high purity copper, in which the copper has substantially the same purity as the later deposited copper used to fill the via. The basic metal layer may comprise metals other than copper, on the condition that the metal provide sufficient coverage to the inner wall of the via and that it provide sufficient conductivity for the electrodeposited copper to adhere. Thus, for example, in various embodiments, the metals other than copper may include gold, silver, platinum, palladium, aluminum, or any of the transition metals. However, for reasons that will be readily apparent to the person of skill in the art, copper normally would be the most preferred metal for use in the basic metal layer.

As noted above, a barrier layer may be formed in the via. The barrier layer may be needed to prevent diffusion of the copper of the TSV into the substrate in which the TSV is located. The barrier layer may be made of any material that provides a sufficient barrier to diffusion of copper into the substrate. The barrier layer may be comprised of any appropriate materials that prevent diffusion of copper atoms into the substrate, or that enable the barrier layer as a whole to inhibit such diffusion. For example, the barrier layer may be comprised of one or more layers including materials, such as tantalum nitride, titanium nitride and/or other suitable materials. Thus, the barrier layer is or comprises a material which inhibits the diffusion of copper into the substrate in which the TSV is formed, or the barrier layer contains a material or sub-layer which inhibits such diffusion of copper. In one embodiment, the barrier layer comprises tantalum nitride. In one embodiment, the barrier layer comprises tantalum nitride and is covered by a liner layer of tantalum. The tantalum provides enhanced adhesion of the basic metal layer to the barrier layer. When the vias are formed, e.g., by RIE, the sidewalls of the vias may be rough and "damaged", and the tantalum nitride and tantalum provide both the barrier function and adhesion to the sidewalls.

In one embodiment the barrier layer may be formed of a material such as silicon nitride or silicon carbide or a silicon carbide nitride. Typically, the barrier layer may be formed by advanced well-established sputter deposition techniques or by atomic layer deposition (ALD), depending on the device and process requirements.

In one embodiment, the dielectric layer is present and comprises silicon dioxide. In one embodiment, the dielectric layer is present and comprises silicon nitride. In this embodiment, the silicon nitride may provide dual duty, by forming both a barrier to copper migration and a dielectric layer to prevent current leakage. In such case, as noted, the barrier layer can function both as barrier and as dielectric to provide electrical insulation as well as a barrier to migration of the copper (or other metal used to fill the via).

In one embodiment, a dielectric layer is formed on the inner surface of the vias, during or subsequent to the step of etching to form the initial vias. The oxidation of silicon results in the formation of silicon dioxide, and this dielectric material may be employed to provide electrical isolation of the TSVs from the surrounding silicon substrate, chip or wafer. The dielectric layer may be formed by any suitable process. In another embodiment, a silicon dioxide layer is formed, for example, by a TEOS process or by an oxidation of the silicon sidewalls of the via. Suitable methods for formation of a layer of such dielectric materials are known in the art and may be selected by the person of skill in the art as needed.

In one embodiment, the step of applying is effective to electrodeposit the high purity copper to completely fill the via. Thus, in this embodiment, the step of applying an electrical voltage between the insoluble dimensionally stable anode and the basic metal layer, so that a current flows therebetween is carried out for a time sufficient to electrodeposit high purity copper to completely fill the via and to form a TSV having no inner cavity.

In one embodiment, the deposited high purity copper is either substantially free of internal stress or includes a very low level of internal stress that does not result in bending of the silicon substrate upon subsequent processing. The presence of internal stress in the deposited high purity copper can result in bending or deformation of the substrate upon heating during subsequent process steps. Generally it is desirable that the high purity copper deposit be substantially free of internal stress. Since it may not be possible to completely avoid the presence of all internal stress, as long as the level of internal stress is low enough that there is no bending or deformation of the substrate during subsequent processing, then the level of stress is acceptable.

In one embodiment, the deposited copper is substantially free of voids and non-copper inclusions. It is very desirable that the deposited high purity copper be free of voids and non-copper inclusions. If voids are present, upon subsequent heating, the voids can cause deformation of the substrate. Such deformation would result in an unsatisfactory product. Any non-copper inclusions that might be present would result in a change in the conductivity of the copper, and would therefore interfere with the function of the TSV. For these reasons the high purity copper deposit should not include any substantial amount of non-copper inclusions.

### ELECTROLYTIC BATH

Besides containing at least one copper ion source, preferably a copper salt with an inorganic or organic anion, for example copper sulfate, copper methane sulfonate, copper pyrophosphate, copper fluoroborate or copper sulfamate, the electrolytic bath used for the copper deposition additionally contains at least one substance for increasing the electrical conductance of the bath, for example sulfuric acid, methane sulfonic acid, pyrophosphoric acid, fluoroboric acid or amidosulfuric acid.

In one embodiment, in the electrolytic bath:
the acid is concentrated sulfuric acid at a bath concentration in the range from about 50 to about 350 g/l, or from about 180 g/l to about 280 g/l, or from about 100 g/l to about 250 g/l, or from about 50 g/l to about 90 g/l,
the source of metal ions is copper sulfate pentahydrate (CuSO₄ • 5 H₂O) at a bath concentration of the source compound in the range from about 20 g/l to about 250 g/l, or from about 80 g/l to about 140 g/l, or from about 180 g/l to about 220 g/l
the source of ferrous and/or ferric ions is ferrous sulfate heptahydrate and/or ferric sulfate nonahydrate at a bath concentration of the source compound in the range from about 1 to about 120 g/l, or from about 1 g/l to about 20 g/l, and
the at least one additive comprises one or more of a polymeric oxygen-containing compound, an organic sulfur compound, a thiourea compound or a polymeric phenazonium compound.

Further details regarding the bath and the process are provided as follows.

The electroplating bath according to the invention contains at least one additive compound for controlling the physical-mechanical properties of the copper deposit. Suitable additive compounds are, for example, polymeric oxygen-containing compounds, organic sulfur compounds, thiourea compounds, polymeric phenazonium compounds and polymeric nitrogen compounds, and mixtures or combinations of any two or more of any of these additive compounds.

Suitable, exemplary, polymeric oxygen-containing compounds include one or more of the following:
carboxymethyl cellulose
nonylphenol-polyglycol ether
octanediol-bis-(polyalkyleneglycol ether)
octanolpolyalkyleneglycol ether
oleic acid polyglycol ester
polyethylene-propyleneglycol copolymer
polyethyleneglycol (PEG)
polyethyleneglycol-dimethylether
polyoxypropyleneglycol
polypropyleneglycol
polyvinyl alcohol
stearic acid polyglycol ester
stearyl alcohol polyglycol ether
β-naphthol polyglycol ether.
The polymeric oxygen-containing compounds additive compounds may be contained in the electrodeposition bath at a concentration in the range from about 0.005 g/l to about 20 g/l, and in one embodiment, from about 0.01 g/l to about 5 g/l.

Suitable, exemplary sulfur compounds with suitable functional groups for providing water solubility include one or more of the following:
3-(benzothiazolyl-2-thio)-propylsulfonic acid, sodium salt
3-mercaptopropane-1-sulfonic acid, sodium salt
ethylenedithiodipropylsulfonic acid, sodium salt
bis-(p-sulfophenyl)-disulfide, disodium salt
bis-(ω-sulfobutyl)-disulfide, disodium salt
bis-(ω-sulfohydroxypropyl)-disulfide, disodium salt
bis-(ω-sulfopropyl)-disulfide, disodium salt (SPS)
bis-(ω-suffopropyl)-sulfide, disodium salt
methyl-(ω-sulfopropyl)-disulfide, disodium salt
methyl-(ω-sulfopropyl)-trisulfide, disodium salt
O-ethyl-dithiocarboxylic acid-S-(ω-sulfopropyl)-ester, potassium salt thioglycolic acid
thiophosphoric acid-O-ethyl-bis-(ω-sulfopropyl)-ester, disodium salt
thiophosphoric acid-tris-(ω-sulfopropyl)-ester, trisodium salt.
In addition to the foregoing water-soluble sulfur-containing compounds, a sulfur-containing compound such as disclosed in U.S. Patent No. 7,220,347 may be used. The disclosure of US 7220347 may be consulted for additional relevant information, and the disclosure of US 7220347 is hereby incorporated by reference herein. The water-soluble organic sulfur additive compounds may be contained in the electrodeposition bath at a concentration in the range from about 0.0005 g/l to about 0.4 g/l, and in one embodiment, from about 0.001 g/l to about 0.15 g/l.

Suitable, exemplary thiourea-type compounds include one or more of the following:
thiourea
N-acetylthiourea
N-trifluoroacetylthiourea
N-ethylthiourea
N-cyanoacetylthiourea
N-allylthiourea
o-tolylthiourea
N,N'-butylene thiourea
thiazolidine thiol
4-thiazoline thiol
imidazolidine thiol (N,N'-ethylene thiourea)
4-methyl-2-pyrimidine thiol
2-thiouracil.

Suitable, exemplary phenazonium compounds include one or more of the following:
poly(6-methyl-7-dimethylamino-5-phenyl phenazonium sulfate)
poly(2-methyl-7-diethylamino-5-phenyl phenazonium chloride)
poly(2-methyl-7-dimethytamino-5-phenyl phenazonium sulfate)
poly(5-methyl-7-dimethylamino phenazonium acetate)
poly(2-methyl-7-anilino-5-phenyl phenazonium sulfate)
poly(2-methyl-7-dimethylamino phenazonium sulfate)
poly(7-methylamino-5-phenyl phenazonium acetate)
poly(7-ethylamino-2,5-diphenyl phenazonium chloride)
poly(2,8-dimethyl-7-diethylamino-5-p-tolyl-phenazonium chloride)
poly(2,5,8-triphenyl-7-dimethylamino phenazonium sulfate)
poly(2,8-dimethyl-7-amino-5-phenyl phenazonium sulfate)
poly(7-dimethylamino-5-phenyl phenazonium chloride).

Suitable, exemplary polymeric nitrogen-containing compounds include one or more of the following:
polyethylenimine
polyethylenimide
polyacrylic acid amide
polypropylenimine
polybutylenimine
N-methylpolyethylenimine
N-acetylpolyethylenimine
N-butylpolyethylenimine
poly(dialkylaminoethyl acrylate)
poly(diallyl dimethyl ammonium)
polyvinyl pyridine
polyvinyl amidine
polyallylamine
polyaminesulfonic acid.

The thiourea-type compounds, polymeric phenazonium compounds and polymeric nitrogen containing compounds, as the additive compounds, may be used at a concentration in the range from about 0.0001 g/l to about 0.50 g/l, and in one embodiment, from about 0.0005 g/l to about 0.04 g/l.

In one embodiment, the electroplating bath comprises a quaternary nitrogen-containing compound as a leveler. In addition to the foregoing polymeric nitrogen containing compounds that include a quaternary nitrogen, a quaternary compound such as disclosed in U.S. Patent No. 7,220,347 may be added as described therein. The disclosure of US 7220347 may be consulted for additional relevant information.

As noted above, in order to achieve the effects, according to the invention, when using the claimed process, Fe(II) and/or Fe(III) compounds are contained in the bath. Suitable iron salts are both the iron(II)-sulfate-heptahydrate and iron(III)-sulfate-nonahydrate, from either or both of which the effective Fe²⁺/Fe³⁺ (Fe(II)/Fe(III)) redox system is formed after a short operational time. These salts are mainly suitable for aqueous, acidic copper baths. Other water-soluble iron salts may also be used, for example iron perchlorate. Salts which contain no (hard) complex formers are advantageous. Such complex formers may be biologically non-degradable or only may be degradable with some difficulty, thus such salts may create problems when disposing of rinse water (for example iron ammonium alum). Iron compounds having anions which lead to undesirable secondary reactions in the case of the copper deposition solution, such as chloride or nitrate for example, should not be used, if possible. In consequence, carboxylates of iron ions, such as acetate, propionate and benzoate, as well as the hexafluorosilicates, are also advantageous. Suitable systems employing the Fe²⁺/Fe³⁺ redox system are disclosed, for example, in U.S. Patent Nos. 5,976,341 and 6,099,711, which may be consulted for additional details on this system.

The concentration of the iron ion substance(s) may be as follows. In one embodiment, the iron ions are added as iron(II)-sulfate (FeSO₄ · 7 H₂O) at a concentration in the range from about 1 g/l to about 120 g/l, and in one embodiment from about 20 g/l to about 80 g/l. In one embodiment, the bath is prepared to initially contain from about 1 g/l to about 30 g/l ferrous ions (based on actual Fe²⁺ content, added as, e.g., ferrous sulfate heptahydrate) and from about 1 g/l to about 30 g/l ferric ions, in one embodiment, from about 2 to about 10 g/l, and in another embodiment, from about 3 to about 5 g/l (based on actual Fe³⁺ content, added as, e.g., ferric sulfate nonahydrate). In one embodiment, the bath is prepared to initially contain from about 2 g/l to about 20 g/l ferrous ions (based on actual Fe²⁺ content, added as, e.g., ferrous sulfate heptahydrate) and from 4 g/l to about 20 g/l ferric ions (based on actual Fe³⁺ content, added as, e.g., ferric sulfate nonahydrate). In one embodiment, the bath is prepared to initially contain from about 3 g/l to about 10 g/l ferrous ions (based on actual Fe²⁺ content, added as, e.g., ferrous sulfate heptahydrate) and from 5 g/l to about 20 g/l ferric ions (based on actual Fe³⁺ content, added as, e.g., ferric sulfate nonahydrate). As will be recognized, since there is a continuous cycling of the ferrous and ferric ions in the redox system, the actual concentrations of both ions are likely to vary from the initial concentrations.

Since the copper ions consumed during the deposition from the deposition solution cannot be directly supplied by the anodes by dissolution when insoluble anodes are used, these copper ions are supplemented by chemically dissolving corresponding copper parts or copper-containing shaped bodies. In the redox system, copper ions are formed from the copper parts or shaped bodies in a redox reaction by the oxidizing effect of the Fe(III) compounds contained in the deposition solution, in which the Fe(III) ions are reduced to Fe(II) ions by the copper metal being oxidized to form Cu(II) ions in the electroplating bath, as described above. By means of this formation of the copper ions, the total concentration of the copper ions contained in the deposition solution can be kept relatively constant, and since they are insoluble, the anodes remain the same uniform size. The deposition solution passes from the copper ion generator back again into the electrolyte chamber which is in contact with the wafers and the anodes. As will be recognized, the following reactions take place:

At the anodes:

Fe²⁺ → Fe³⁺ + e⁻

At the copper source:

Cu⁰ + 2 Fe³⁺ → Cu²⁺ + 2 Fe²⁺

At the cathode (e.g., at the semiconductor substrate):

Cu²⁺ + 2 e⁻ → Cu⁰ (main reaction)

Fe³⁺ + e⁻ → Fe²⁺ (minor reaction)

Thus, the system may be initialized with either or both a source of ferrous ion or a source of ferric ion, since the redox reaction interconverts these ions as the process proceeds. In one embodiment, the system is initialized with both a source of ferrous ions and a source of ferric ions. As a result of this process, the concentration of the copper ions in the deposition solution can be kept constant very easily, which helps to maintain uniformity of the copper deposit.

In one embodiment, the electrodeposition bath is substantially free of added chloride, for example sodium chloride or hydrochloric acid. Chlorides have been used in similar electroplating baths, but in accordance with this embodiment of the present invention, the chloride is omitted. As used herein, when a possible bath component is omitted from the bath, or when a bath is referred to as being "free of" a component, this means that none of the component is intentionally added to the bath. Small amounts of such components may be present as impurities, but they are not added intentionally.

In one embodiment, chloride ion is present at a concentration up to about 20 ppm, and in another embodiment, chloride ion is present at a concentration up to about 50 ppm, and in another embodiment, chloride ion is present at a concentration up to about 100 ppm.

For the electrolytic copper deposition of the present invention, a voltage is applied between the semiconductor substrate and the anode, the voltage being so selected that an electric current of 0.05 amps per dm² (A/dm²) to 20 A/dm², in one embodiment, 0.2 A/dm² to 10 A/dm² and, in another embodiment, 0.5 A/dm² to 5 A/dm², where the current flows are expressed as amps per dm² of, e.g., semiconductor substrate surface, assuming that the plating is applied to the entire surface of the substrate.

In one embodiment, a pulse current or pulse voltage method is used. In the pulse current method, the current between the workpieces, polarized as the cathode, and the anodes, is set galvanostatically and modulated per unit time by suitable means. In the pulse voltage method, a voltage between the wafers, as cathodes, and the counter-electrodes, as anodes, is set potentiostatically, and the voltage is modulated per unit time so that a current is set which is variable per unit time.

The method, which is known as the reverse pulse method, in one embodiment is used with bipolar pulses. Those methods are especially suitable, in which the bipolar pulses comprise a sequence of cathodic pulses, lasting from 20 milliseconds to 100 milliseconds, and anodic pulses lasting from 0.3 milliseconds to 10 milliseconds. In one embodiment, the peak current of the anodic pulses is set to at least the same value as the peak current of the cathodic pulses. In one embodiment, the peak current of the anodic pulses is set two to three times as high as the peak current of the cathodic pulses.

In one embodiment, the electrical voltage is applied in a pulse current or a pulse voltage. In one embodiment, the electrical voltage is applied in a reverse pulse form with bipolar pulses. These processes are well known in the art, and detailed parameters for use with some embodiments of the present invention are described in more detail in the following.

In one embodiment, the electrical voltage is applied in a reverse pulse form with bipolar pulses including a forward current pulse and a reverse current pulse. In one embodiment, the duration of the reverse current pulse is adjusted to about 1 to about 20 milliseconds, and in another embodiment, the duration of the reverse current pulse is adjusted to about 2 to about 10 milliseconds. In one embodiment, the duration of the forward current pulse is adjusted to about 10 to about 200 milliseconds, and in another embodiment, the duration of the forward current pulse is adjusted to about 20 to about 100 milliseconds.

In one embodiment, peak current density of the forward current pulse at a work piece surface is adjusted to a maximum of about 15 amps per square decimeter (A/dm²), and in another embodiment, peak current density of the forward current pulse at a work piece surface is adjusted to a maximum of about 1.5 to about 8 A/dm². In one embodiment, the peak current density of the reverse current pulse at a work piece surface is adjusted to a maximum of about 60 A/dm², and in another embodiment, peak current density of the reverse current pulse at a work piece surface is adjusted to a maximum of about 30 to about 50 A/dm².

In one embodiment, a first current pulse is shifted with respect to a second current pulse by about 180°. A pause of suitable duration may be included between the first current pulse and the second current pulse. A suitable duration may range, for example, from about 1 millisecond to about 5 milliseconds, and in one embodiment is from about 2 milliseconds to about 4 milliseconds, and in one embodiment, is about 4 milliseconds.

In one embodiment, when compared to a copper electrodeposition system in which the redox system of the present invention is not used or not present, the redox system according to the present invention exhibits reduced consumption of organic additives. This unexpected benefit is believed to result from reduced oxidation of the organic additives at the anodes. In one embodiment, when compared to a copper electrodeposition system in which the redox system is not used or present, the redox system according to the present invention consumes only about 30% of the organic additives that would be consumed by the non-redox system. This benefit is in addition to the benefit of improved additive stability when the bath temperature is maintained lower than the temperature of the heated substrate, in accordance with the invention.

In one embodiment, no soluble anodes made of copper are used as the anodes; rather, dimensionally stable, insoluble, inert anodes are used. By using the dimensionally stable, insoluble (inert) anodes, a constant spacing can be set between the anodes and the wafers. The anodes are easily adaptable to the wafers in respect of their geometrical shape and, contrary to soluble anodes, they substantially do not change their geometrical external dimensions. In consequence, the spacing between the anodes and the wafers, which can influence the distribution of layer thickness on the surface of the wafers, remains constant. Without such constant spacing, variations in layer thickness and quality may result, causing non-uniform copper deposits.

In one embodiment, the wafers are processed in a horizontal orientation for the copper deposition. Anodes in the deposition bath, also kept horizontal, are disposed directly opposite the wafers. In another embodiment, the anodes are maintained parallel to and at a constant distance from the surface of the substrate, in any orientation in which the wafers are processed. Since dimensionally stable insoluble electrodes are employed, the distance between the anodes and the cathodic parts of the wafer or semiconductor device is maintained substantially constant.

The process according to the invention is especially suitable for filling vias to form TSVs in silicon substrates in, e.g., semiconductor devices, silicon wafers and MEMS devices.

In one embodiment, a barrier layer is formed on the inner sidewalls of the TSV, in order to provide a barrier to diffusion of the later-deposited copper into the silicon of the substrate through which the TSV is formed.

The basic metal layer is formed over the barrier layer, as described above, to provide a conductive surface onto which the subsequent high-purity copper fill for the TSV will be deposited.

After the basic metal layer has been formed, the copper fill for the TSV is electrolytically deposited according to the above-described process.

In one embodiment, the process of the present invention is integrated into a semiconductor fabrication process, and includes, in this order:
lithography and masking for the etch process,
DRIE or laser etching for creation of the TSV,
optionally, formation of a dielectric isolation layer by an oxidation,
formation of a barrier layer by physical vapor deposition, thermal and/or CVD, on the inner surface of the via or on the dielectric layer when present,
formation of a basic metal or seed layer by an appropriate method, such as a copper electroless process or sputtering,
copper electrodeposition filling of the TSV as described in detail herein,
appropriate treatment such as CMP and cleaning, to complete formation of the filled TSV.

The wafer or semiconductor device may then be processed using standard technology, such as CMOS, and later subjected to processes such as thinning, lithography, solder bump, dicing and then die-to-die, die-to-wafer, wafer-to-wafer or other appropriate 3D construction by various known methods. In general, manufacturing aspects relating to TSVs may include via formation, metallization, wafer thinning, alignment, and bonding.

The following non-limiting examples are provided to illustrate an embodiment of the present invention and to facilitate understanding of the invention, but are not intended to limit the scope of the invention, which is defined by the claims appended hereto.

### Example 1:

To produce a TSV filled with a high purity copper deposit, a wafer is provided with vias having a diameter of about 10 microns and a depth of about 50 microns. The inner sidewalls of the vias are coated with a diffusion barrier layer formed from tantalum nitride applied by sputtering. The tantalum nitride layer is covered with a liner layer of tantalum applied by sputtering. Next, the liner layer is coated with a copper basic metal layer by sputtering, in which the copper basic metal layer has a thickness of about 0.1 micron. The wafer is then immersed in a copper deposition bath described below in which the wafer is connected as a cathode, heated to about 40°C, an insoluble anode is included in the apparatus, and the bath is maintained at room temperature. The via is filled with high purity copper by electrodeposition from the bath having the following ingredients, to form the TSVs in accordance with the present invention:

| | |
|---|---|
| H₂SO₄, 98% by wt. | 130 g/l |
| CuSO₄ · 5 H₂O | 70 g/l |
| FeSO₄ · 7 H₂O | 15 g/l and |
| polyethylene glycol | 8 g/l |

in water.

The high purity copper is electrodeposited under the following conditions:
cathodic current density 4 A/dm²
circulation of the bath 5 l/min
bath cooled to remain at room temperature (20°C ± 2°C)
substrate (wafer) heated to 40°C (set point, actual wafer temperature may be slightly lower).

Pulsed current is applied with the parameters shown in the table below.

### Example 2:

Copper stress in TSVs deposited by different plating methods using the bath of Example 1, in accordance with the invention, including heating the wafer substrate and maintaining the bath at the lower temperature, and in a first comparative example, using a similar bath and a soluble copper anode without the added Fe²⁺/Fe³⁺ ions and without heating the wafer substrate and in a second comparative example using a similar bath including all the above ingredients but without heating the wafer substrate, in which pulsed current is applied with the parameters shown in the table below:

| Examples | I_{forward}/Iᵣₑᵥₑᵣₛₑ in A/dm² | Pulse in milliseconds Forward- / Reverse-Pulse | Pulse-gap in milliseconds | Phase shift in degrees |
|---|---|---|---|---|
| 1 and 2 | 6/40 | 72/4 | 4 | 180 |

| Electrodeposition Method | Stress | Cu Rate |
|---|---|---|
| Unheated wafer, soluble copper anode: (prior art) | 163.2 ± 34.3 MPa | <1 *µ*/min |
| Unheated wafer w/ Cu/Cu²⁺ / Fe²⁺/Fe³⁺ redox (prior art) | 113.4 ± 40.1 MPa | ≈1 *µ*/min |
| Heated wafer w/ Cu/Cu²⁺ / Fe²⁺/Fe³⁺ redox (present invention) | 66.9 ± 9.8 MPa | ≈2 *µ*/min |

The internal stress is measured as deposited without a post-annealing step. The measurement is via wafer warpage and bow (LASER measurement). The equipment used was a KLA-TENCOR FLX-2320 thin film stress measurement system, copper film thickness 1 micron, wafer thickness 850 micron.

As is clearly shown by the data from Example 2, when TSVs are filled in accordance with the present invention, significantly lower and significantly more consistent stress levels are obtained in the TSVs, and the plating rate is noticeably greater.

### Additional Examples

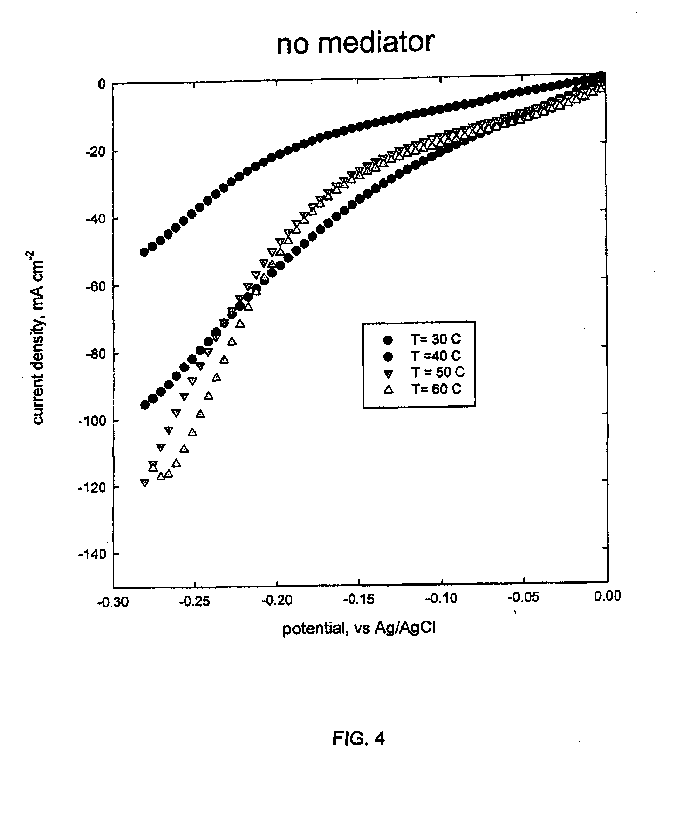

The following examples show the influence of holding the substrate at an elevated temperature relative to the electrolyte, which is maintained at room temperature, in accordance with some embodiments of the invention. In general, the polarization curves in Figs. 4-8 show that plating rate is enhanced with increasing temperature, with some exceptions. Although not to be bound by theory, the complexity of the observations is tentatively interpreted related to differences in action between the dependence on temperature (e.g., adsorption and desorption changes with temperature) of the organic additives.

### Experimental:

Testing may be conveniently carried out in a microfluidic electrochemical cell. A commercial feedback controller is used for the temperature control of the substrate, with heat applied from a laboratory heating pad. It is estimated that the actual substrate temperature is approximately 3°C less than the reported controller values (values shown in Figs. 4-8). Since the residence time of the electrolyte inside the microfluidic channels is very small, the bulk of the electrolyte remains unheated (except in the small diffusion layer adjacent to the heated substrate). The applied potential is swept at 10 mV/s from 100 mV to -275 mV and back. For clarity, only the backward sweep is shown in Figs. 4-8.

### Electrolyte composition:

50 g/l Cu,
100 g/l H₂SO₄,
50 ppm chloride ion,
2 ppm SPS, and
300 ppm PEG.
Fe⁺²/Fe⁺³ (mediator), when present, as Fe, 12 g/l.

### Results:

**FIG. 4****,** labeled "no mediator", shows a trend that deposition rate increases with temperature, although the curves intersect, suggesting that an increase is not seen at all applied potentials.

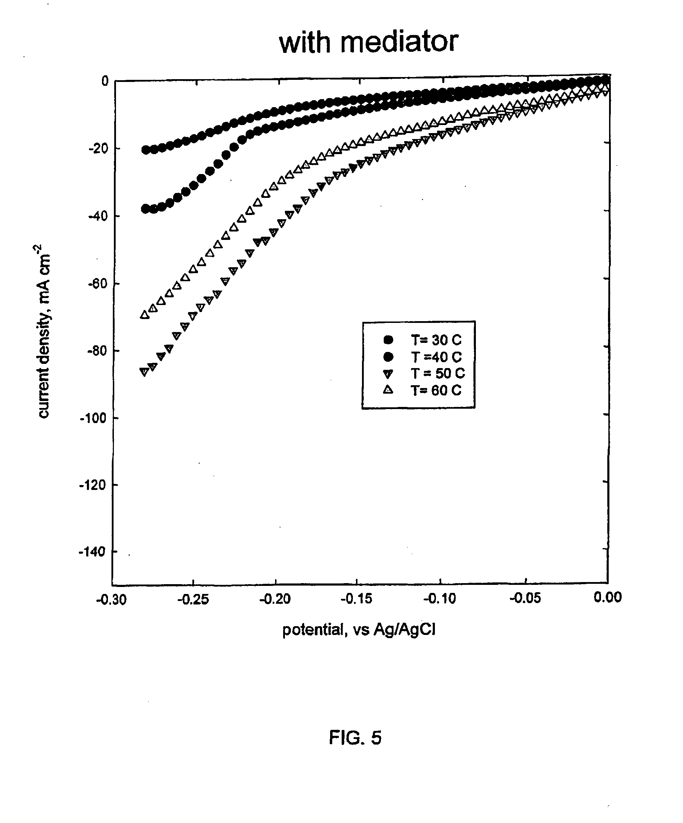

As shown in **FIG. 5****,** labeled "with mediator", the curves are more easily distinguishable when the mediator is present. Note however, that the plating rate, as estimated from the polarization curves, at 50°C is higher than that predicted at 60°C, at least at some applied potentials. This suggests that the expected increase in plating rate with substrate temperature is not always observed, and that other factors may be involved, such as the additive composition or change in activity of one or more of the additives at the higher temperature. Repeated measurements verify these surprising results.

The polarization curves shown in **FIGS. 4** and **5** show that at higher temperatures, higher current densities are present, but that with the mediator present, a lower current is present than without the mediator. This is believed to be due to the anode reaction of Fe⁺² → Fe⁺³ and the subsequent reaction Cu⁰ + 2 Fe⁺³ → Cu⁺² + 2 Fe⁺², which requires a lower current density.

The polarization curves shown in **FIGS. 4** and **5** are valuable to provide a quick overview of the dependence of the deposition rate on applied potential. However, for a TSV application, deposition times may be long, and it is relevant to understand the long-time behavior of the plating rate (or electrode polarization) keeping applied potential (or current) steady.

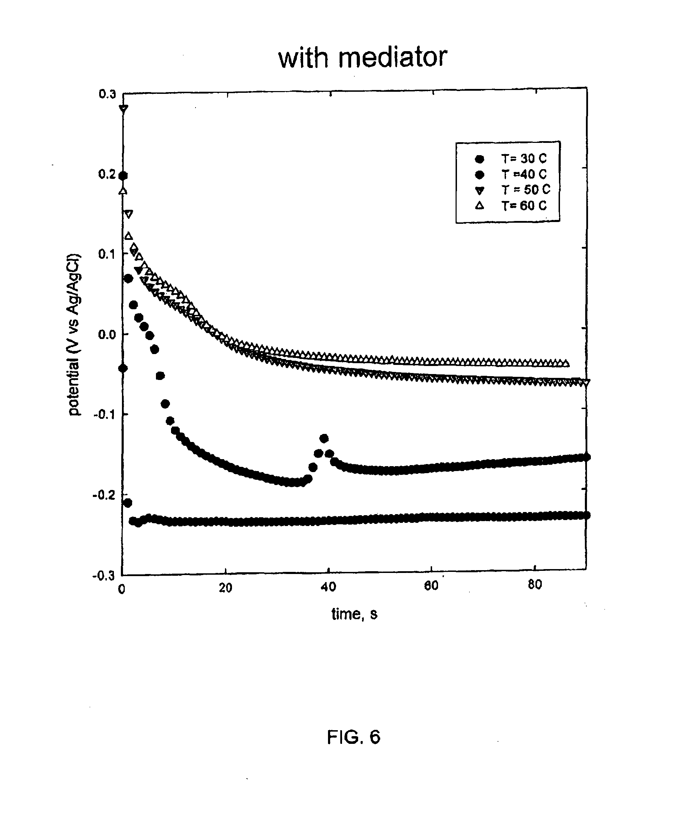

**FIG. 6** shows the polarization for a mediator-containing electrolyte as a function of time for different substrate temperatures. For each case, the current density is set at 10 mA cm⁻². At the higher temperatures, the electrodes are less polarized (more positive). **FIG. 6** shows the depolarization of the electrodes at higher temperatures: The polarization is an effect of the additives adsorbed at the electrode surfaces, the more additives present there, the more polarization. As the temperature increases, the thermodynamics of the additive adsorption changes the situation such that effectively a smaller amount of the additives are adsorbed on the surface, and hence less polarization is observed. In addition, the electrolyte becomes more conductive as temperature increases. Normally the change in conductivity with temperature is accounted for and the effects subtracted. The polarization is measured by applying a constant current density and measuring the potential between the two electrodes (this is plotted on the y-axis relative to a reference electrode potential).

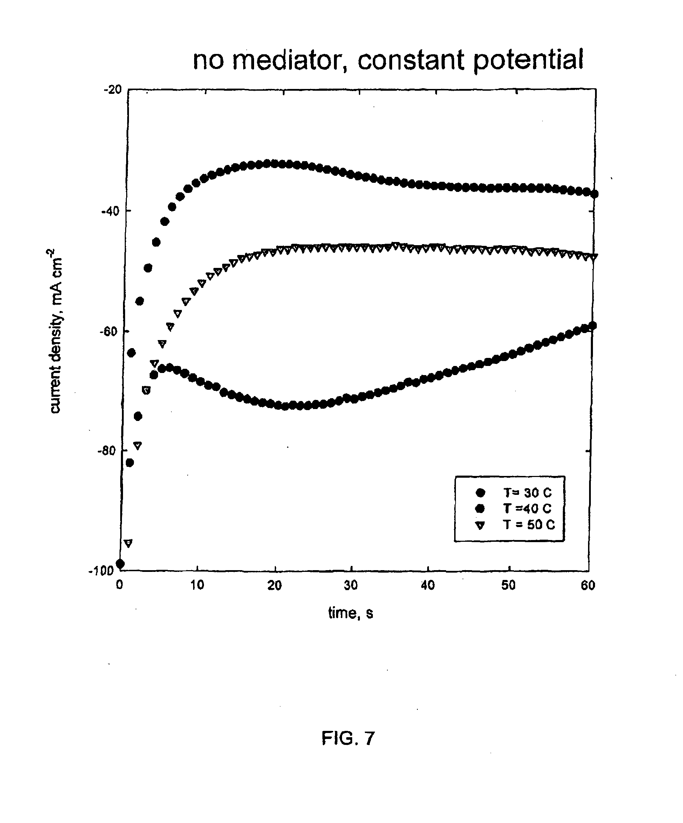

FIG. 7 shows the current density response to holding an electrode at a constant potential of -250 mV for an electrolyte containing the organic additives but no mediator. Here, the maximum in plating rate is observed at 40°C, instead of the expected 50°C. Again, although not to be bound by theory, this is interpreted as being related to temperature-dependent desorption and adsorption kinetics of the additives. FIG. 7 shows the effect of applying a constant potential starting at t=0, with no potential before t = 0. The transient is the effect of setting up a new equilibrium. From an increasing temperature perspective, we would expect the two following effects:
1) a faster transient for higher temperatures
2) a higher final current density (more negative current density on the y-axis in FIG. 7) due to a smaller amount of adsorbed additives at higher temperatures, and a higher conductivity of the electrolyte at higher temperatures. In FIG. 7, there is an apparent anomaly with the 40°C sample.

**FIG. 8** is a schematic cross-sectional view of a 3D device 100 including a substrate 102 having mounted thereon two wafers 104 and 106, including copper-filled TSVs 108a, 108b, 108c, 110a, 110b and 110c, in which the TSVs have been electrodeposited by a process according to an embodiment of the present invention. The substrate 102 may be any suitable substrate, such as a chip, a wafer or some other substrate upon which one or more chips or wafers is to be attached to form a 3D device such as the 3D device 100 depicted in **FIG. 8****.** As shown in **FIG. 8****,** the 3D device 100 further includes solder bumps 112a, 112b, 112c, 114a, 114b and 114c, by which the respective filled TSVs 108a, 108b, 108c, 110a, 110b and 110c are electrically interconnected to each other and to electrical wiring 116 in the substrate 102. Finally, as shown in **FIG. 8****,** the 3D device 100 further includes under fill material 118 between the wafer 104 and the substrate 102 and between the wafer 104 and the wafer 106. It is noted that **FIG. 8** is a highly schematic depiction of a 3D device, and for the sake of clarity and simple explanation omits the various functional elements that would be present in the various elements of the 3D device, so as to more clearly depict the important elements of the 3D device which can be formed by a process including various embodiments of the present invention.

**FIGS. 9-16** are schematic cross-sectional views of steps in a process of forming TSVs in a wafer and mounting the wafer onto a substrate to form part of a 3D device such as the 3D device 100 shown in **FIG. 8****,** in accordance with an embodiment of the present invention. The process depicted in **FIGS. 9-16** is presented schematically and, as will be understood, may be carried out in the appropriate selected order as described above, with respect to the "via first" or "via last", before or after FEOL and before or after bonding.

**FIG. 9** depicts a silicon substrate, such as a wafer, chip or other silicon substrate which may be used, e.g., in a semiconductor device, through which TSVs are to be formed.

In the next step of a process according to an embodiment of the present invention, TSVs are formed in the silicon substrate 104. As disclosed above, any suitable method of forming TSVs may be used, and in one embodiment, the method is DRIE. This formation is indicated by the arrow leading from **FIG. 9** to **FIG. 10****.**

**FIG. 10** depicts the silicon substrate of **FIG. 9** after the TSVs 120a, 120b and 120c have been formed through most of the thickness of the silicon substrate 104. It is noted that, for simplicity, only three TSVs 120a-120c are depicted in **FIGS. 8-15****,** but as disclosed above, a given wafer or semiconductor device may contain hundreds or thousands of such TSVs. It is further noted that, for simplicity, the TSVs 120a-120c in **FIG. 10****,** and in all of the **FIGS. 8 and 10****-16,** are shown as having vertical, parallel sidewalls; this is for purposes of ease of illustration and is not intended to depict a required situation. As is known, while the sidewalls may be vertical or substantially vertical, in some embodiments, the sidewalls in TSVs generally taper slightly from top to bottom, i.e., from the opening of the via to the bottom of the via, so that the diameter at the bottom is slightly smaller than the diameter at the top opening or mouth of the via.

Subsequent to formation of the TSVs 120a-120c, in the next step of a process according to an embodiment of the present invention, on the entire inside surface of the sidewalls of each TSV 120 a dielectric layer 122 optionally may be deposited, as shown in FIGS. **11** and **11a****.** Due to the scale of **FIG. 11****,** an expanded view of a portion of the TSV 120c and the subsequently applied layers are shown in **FIGS. 11a, 11b, 11c, 11d and 11e****.** As described above, the dielectric layer 122 optionally may be provided as an electrical insulation layer between the subsequently formed conductive fill of the TSV and the adjacent silicon substrate 104. In this embodiment, the entire inner surface of each TSV 120a-120c is covered with the dielectric layer 122. As will be understood, the relative proportions of the layers and the substrate 104 are not to scale. As noted above, the dielectric layer is optional, and in an appropriate embodiment, a separate step to form the dielectric layer 122 illustrated in **FIG. 11a** can be omitted, e.g., when the barrier layer subsequently formed also functions as a dielectric, or when a dielectric layer 122 is created by the via-forming etching step.

Next, in one embodiment, a barrier layer 124 is deposited or formed over the dielectric layer 122, as shown in **FIG**. **11b****.**

The barrier layer may be formed of a material such as, for example, tantalum nitride (TaN), or combination of TaN covered by tantalum (Ta) as described above, or other material known to function as a barrier to copper migration. The barrier layer 124 is provided in order to prevent migration of the later-deposited copper into the silicon substrate 104. The barrier layer may be deposited by any appropriate method known in the art for deposition of such a layer.

Alternatively, as shown in **FIG. 10****,** the step forming the barrier layer may be omitted, e.g., when the dielectric layer 122 functions as a sufficient barrier to prevent migration of copper, as indicated by the arrow directly from **FIG. 11a** to FIG. 11c.

Following formation of the barrier layer 124, as shown in **FIG. 11c****,** in the next step of a process according to an embodiment of the present invention, a conductive basic metal or seed layer 126 is deposited on the surface of the barrier layer 124 lining the TSVs 120a-120c. In the alternate embodiment above, when no separate barrier layer is formed, as shown by the arrow from **FIG. 11a** to **FIG. 11c****,** the conductive basic metal layer 126 may be formed directly on the dielectric layer 122.

In another embodiment, as shown in **FIGS. 10****,** **11d** and **11e****,** subsequent to formation of the TSVs 120a-120c, in the next step of a process according to an embodiment of the present invention, no dielectric layer is formed, and a barrier layer 124 is formed directly on the inside surface of the sidewalls of each TSV 120, as shown in **FIG. 11d****,** as described in the following, except that there is no dielectric layer separately formed. In this case, the substrate 104 in **FIG. 11** would have the TSVs 120 with no layer 122, and the other layers (barrier, basic metal and electrodeposited metal) would be formed as described below but without a dielectric layer on the TSV wall under the layers.

In the alternative embodiment in which no dielectric layer is formed, the vias shown in **FIG. 10** have the barrier layer 124 formed directly on the inner surfaces of the vias 120a-c, as illustrated in **FIG. 11d****.** In this embodiment, the basic metal layer 126 is formed on the barrier layer 124, and shown in **FIG. 11e****,** and then the metal is electroplated onto the basic metal layer 126 to fill the vias, to form a product such as shown in **FIGS. 12** and **12a****,** except that the dielectric layer 122 in FIG. 12a would not be present.

As described above, the basic metal layer 126 may be any appropriate conductive metal layer, and in one embodiment is copper, and in another embodiment is high-purity copper. The basic metal layer 126 may be deposited by any appropriate method known in the art for deposition of such a layer. The basic metal layer 126 provides a conductive surface upon which the electrodeposition of the TSV fill metal can take place.

The next step of a process according to an embodiment of the present invention, each of the TSVs 120a-120c are filled with high purity copper by an electrodeposition process as described above, to form the filled TSVs 108a-108c, as depicted in FIGS. **12** and **12a****.** The high purity copper is electrodeposited using the redox system described above, such that the copper is deposited on the basic metal layer 126, and the high purity copper completely fills the TSVs with essentially no voids or inclusions, in accordance with an embodiment of the present invention.

It is noted that, in FIGS. **8** and **12****-16,** although the dielectric layer 122, the barrier layer 124 and the basic metal layer 126 are not clearly shown due to the scale of the drawings, they are deemed to be present, having been formed as described above, and shown in FIGS. **11a, 11b, 11c, 11d** and **11e****.** It is also noted that, although not shown in the foregoing figures, a liner layer as described above may be formed on the barrier layer when needed, e.g., to enhance adhesion of the basic metal layer 126 to the barrier layer 124.

**FIGS.13-16** schematically depict certain steps in a process of attaching a silicon substrate 104 containing the filled TSVs 108a-108c to the substrate 102. Also, at this time, any needed removal of the variously deposited layers from other surfaces of the wafer may be carried out. For example, the copper electrodeposition may cover the entire upper surface of the wafer, and may be removed, *e.g.*, by chemical-mechanical polishing (CMP). Suitable methods for removing excess material deposited in the course of carrying out the processes described herein may be selected as needed by those of skill in the art. These layers and steps for removing them are not shown in the drawings, but will be readily understood and appreciated by the skilled person.

In **FIG. 13****,** the wafer containing the newly formed TSVs 108a-108c has been thinned, thus exposing the lower or bottom end of the TSVs 108a-108c to enable electrical connection of the TSVs 108a-108c in subsequent steps. The thinning may be carried out by any known method for thinning semiconductor wafers, chips, etc., but is most likely by CMP.

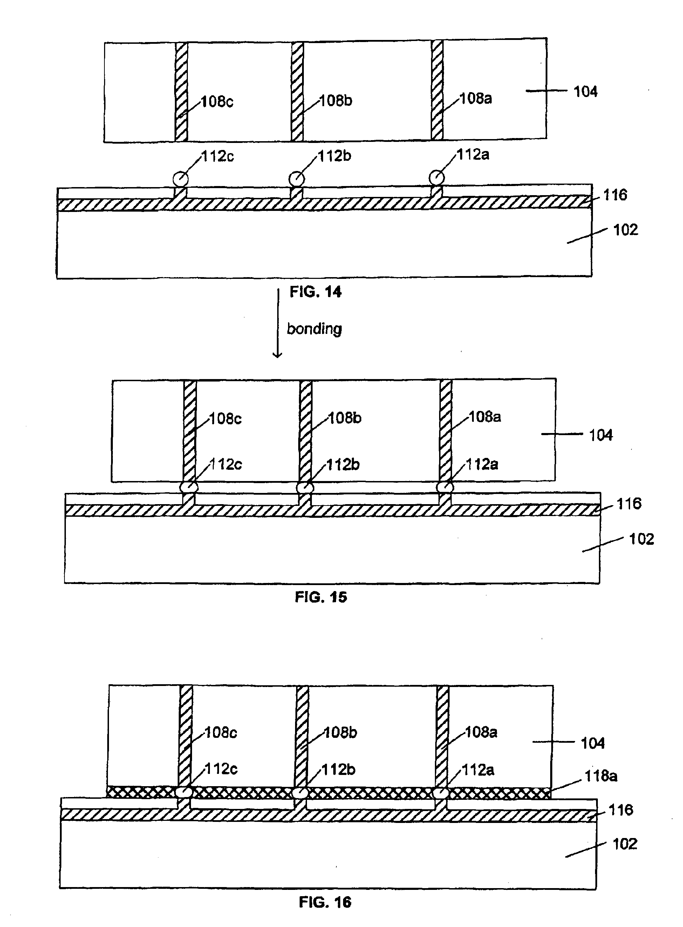

In **FIG. 14****,** the silicon substrate 104 containing the filled TSVs 108a-108c is positioned above or adjacent to the substrate 102. As shown, the substrate 102 includes the electrical wiring 116, similar to that shown in **FIG. 8****.** As shown, in FIG. 14, solder beads or balls 112a, 112b and 112c have been placed in locations at which the TSVs 108a-108c will contact exposed portions of the electrical wiring 116. The solder beads 112a-112c may be formed of any suitable material, such as tin-lead solder or any other known solder material used for making such attachments, and may be deposited according to any known method.

As depicted in **FIG. 15****,** the next step is contacting each of the TSVs 108a-108c to the solder beads 112a-112c, which are in turn in contact with the electrical wiring 116 in the substrate 102, and thereby to create an electrical connection between the respective TSVs 108a-108c to the electrical wiring 116 via the respective solder beads 112a-112c. The contacting may be by any known method.

As depicted in **FIG. 16****,** the underfill material 118a can be added to fill the or any space remaining between the silicon substrate 104 and the substrate 102. In one embodiment, the underfill material is placed following the step of contacting the TSVs to the solder beads, and in another embodiment, the underfill material 118a is applied to the substrate prior to the contacting. As will be understood, the underfill material 118a may be applied before or after the solder beads.

It is noted that, in an embodiment in which the TSV is formed after bonding in a "via last" approach, the step of etching may form TSVs that penetrate through the entire thickness of the silicon substrate (not shown). In some such cases, a lower layer to which the wafer has already been bonded may act as an etch stop layer.

It is noted that, throughout the specification and claims, the numerical limits of the disclosed ranges and ratios may be combined, and are deemed to include all intervening values. Thus, for example, where ranges of 1-100 and 10-50 are specifically disclosed, the ranges of 1-10, 1-50, 10-100 and 50-100 are deemed to be within the scope of the disclosure, as are the intervening integral values. Furthermore, all numerical values are deemed to be preceded by the modifier "about", whether or not this term is specifically stated. Finally, all possible combinations of disclosed elements and components are deemed to be within the scope of the disclosure, whether or not specifically mentioned. That is, terms such as "in one embodiment" are deemed to disclose unambiguously to the skilled person that such embodiments may be combined with any and all other embodiments disclosed in the present specification.

While the principles of the invention have been explained in relation to certain particular embodiments, and are provided for purposes of illustration, it is to be understood that various modifications thereof will become apparent to those skilled in the art upon reading the specification. Therefore, it is to be understood that the invention disclosed herein is intended to cover such modifications as fall within the scope of the appended claims. The scope of the invention is limited only by the scope of the appended claims.

## Claims

1. A process of electrodepositing a metal in a via in a silicon substrate to form a through-silicon-via (TSV), comprising:
providing a silicon substrate containing at least one via, wherein the via includes an inner surface having an internal width dimension in the range from about 1 micron to about 30 microns, a depth from about 5 microns to about 450 microns and a depth:width aspect ratio of at least 3:1, and the via further includes a basic metal layer covering of the inner surface with a thickness of basic metal to obtain sufficient conductance for subsequent electrodeposition of the metal;
providing an electrolytic bath in an electrolytic metal plating system with the basic metal layer connected as a cathode,
the system further comprising
a chuck adapted to hold the silicon substrate and to heat the silicon substrate uniformly to a first temperature,
a temperature control device to maintain temperature of the electrolytic bath at a second temperature, wherein the temperature control device comprises a cooling unit,
an insoluble dimensionally stable anode and a metallic source of the metal, wherein the electrolytic bath comprises an acid, a source of ions of the metal, a source of ferrous and/or ferric ions, and at least one additive for controlling physical-mechanical properties of deposited metal; and
applying an electrical voltage between the insoluble dimensionally stable anode and the basic metal layer, so that a current flows therebetween through the bath for a time sufficient to electrodeposit the metal on the basic metal layer to form a TSV, wherein a Fe⁺²/Fe⁺³ redox system is established in the bath to provide additional ions of the metal to be electrodeposited by dissolving ions of the metal ions from the metallic source and wherein the first temperature is maintained in a range from about 30°C to about 60°C and the second temperature is maintained by the cooling unit at a temperature (a) at least 5°C lower than the first temperature and (b) in a range from about 15 °C to about 35 °C.

2. The process of claim 1 wherein the metal is copper.

3. The process of any preceding claim wherein the inner surface is covered with a layer of a dielectric material and the basic metal layer covers the layer of a dielectric material.

4. The process of any preceding claim wherein the inner surface is covered with a layer of a dielectric material, which layer of a dielectric material is covered by a barrier layer, and the basic metal layer covers the barrier layer.

5. The process of either claim 3 or claim 4 wherein the dielectric layer comprises silicon dioxide.

6. The process of claim 1 wherein a barrier layer is formed on the inner surface.

7. The process of claim 4 or claim 6 wherein the basic metal layer is formed over the barrier layer by one or more of an electroless plating process, a physical deposition process, a chemical vapor deposition process, or a plasma-enhanced chemical vapor deposition process.

8. The process of claim 6 wherein the barrier layer comprises tantalum nitride.

9. The process of claim 8 wherein the barrier layer is covered by a liner layer comprising tantalum.

10. The process of any one of claims 1-9 wherein the applying is effective to electrodeposit the metal to completely fill the via.

11. The process of any preceding claim wherein the deposited metal is either substantially free of internal stress or includes a level of internal stress that does not result in bending of the silicon substrate upon subsequent processing.

12. The process of any preceding claim wherein the basic metal layer has a thickness in the range from about 0.02 µm to about 0.5 µm.

13. The process of any preceding claim wherein the basic metal layer comprises copper.

14. The process of any preceding claim wherein in the electrolytic bath,
the acid is sulfuric acid at a concentration in the range from about 50 to about 350 g/l,
the source of ions of the metal is copper sulfate pentahydrate at a concentration in the range from about 20 to about 250 g/l,
the source of ferrous and/or ferric ions is ferrous sulfate heptahydrate and/or ferric sulfate nonahydrate at a concentration in the range from about 1 to about 120 g/l, and
the at least one additive comprises one or more of a polymeric oxygen-containing compound, an organic sulfur compound, a thiourea compound and a polymeric phenazonium compound.

15. The process of any preceding claim wherein the electrical voltage is applied in a pulse current or a pulse voltage.

16. The process of claim 15 wherein the electrical voltage is applied in a reverse pulse form with bipolar pulses.

17. The process of any preceding claim wherein one or more of the at least one additive undergoes substantial decomposition in the electrolytic bath at the first temperature but does not substantially decompose at the second temperature.

## Patentansprüche

1. Verfahren zum elektrolytischen Abscheiden eines Metalls in einem Durchgangsloch in einem Siliziumsubstrat, um eine Durchkontaktierung (TSV) zu bilden, umfassend:
Bereitstellen eines Siliziumsubstrats, das mindestens ein Durchgangsloch enthält, wobei das Durchgangsloch eine Innenfläche umfasst, die eine innere Weitenabmessung im Bereich von etwa 1 Mikrometer bis etwa 30 Mikrometern, eine Tiefe von etwa 5 Mikrometern bis etwa 450 Mikrometern und einen Formfaktor von Tiefe:Weite von mindestens 3:1 hat, und wobei das Durchgangsloch ferner eine Grundmetallschicht umfasst, die die Innenfläche mit einer Dicke des Grundmetalls bedeckt, um eine ausreichende Leitfähigkeit zum anschließenden Galvanisieren des Metalls zu erhalten;
Bereitstellen eines elektrolytischen Bades in einem elektrolytischen Metallbeschichtungssystem mit einer Grundmetallschicht, die als Katode angeschlossen ist,
wobei das System ferner Folgendes umfasst:
eine Spannvorrichtung, die zum Halten des Siliziumsubstrats und zum gleichmäßigen Erwärmen des Siliziumsubstrats auf eine erste Temperatur ausgelegt ist,
eine Temperaturregelvorrichtung zum Aufrechterhalten der Temperatur des elektrolytischen Bades auf einer zweiten Temperatur, wobei die Temperaturregelvorrichtung eine Kühleinheit umfasst,
eine unlösliche, formstabile Anode und eine Metallquelle für das Metall, wobei das elektrolytische Bad eine Säure, eine Quelle für Ionen des Metalls, eine Quelle von Eisen(II) und/oder Eisen(III)-Ionen und mindestens ein Additiv zum Steuern der physikalisch-mechanischen Eigenschaften des abgeschiedenen Metalls umfasst; und
Anlegen einer elektrischen Spannung zwischen der unlöslichen, formstabilen Anode und der Grundmetallschicht, so dass ein Strom dazwischen durch das Bad über eine Zeit fließt, die zum Galvanisieren des Metalls auf der Grundmetallschicht ausreicht, um ein TSV zu bilden, wobei ein Fe⁺²/Fe⁺³-Redoxsystem im Bad hergestellt wird, um zusätzliche Ionen des Metalls bereitzustellen, die galvanisiert werden sollen, indem Ionen der Metallionen aus der Metallquelle aufgelöst werden, und wobei die erste Temperatur in einem Bereich von etwa 30 °C bis etwa 60 °C liegt und die zweite Temperatur durch eine Kühleinheit auf einer Temperatur von (a) mindestens 5 °C unter der ersten Temperatur und (b) in einem Bereich von etwa 15 °C bis etwa 35 °C gehalten wird.

2. Verfahren nach Anspruch 1, wobei das Metall Kupfer ist.

3. Verfahren nach einem der vorherigen Ansprüche, wobei die Innenfläche mit einer Schicht eines dielektrischen Materials bedeckt ist und die Grundmetallschicht die Schicht eines dielektrischen Materials bedeckt.

4. Verfahren nach einem der vorherigen Ansprüche, wobei die Innenfläche mit einer Schicht eines dielektrischen Materials bedeckt ist, wobei diese Schicht eines dielektrischen Materials durch eine Sperrschicht bedeckt ist und die Grundmetallschicht die Sperrschicht bedeckt.

5. Verfahren nach Anspruch 3 oder 4, wobei die dielektrische Schicht Siliziumdioxid umfasst.

6. Verfahren nach Anspruch 1, wobei eine Sperrschicht auf der Innenfläche gebildet ist.

7. Verfahren nach Anspruch 4 oder 6, wobei die Grundmetallschicht auf der Sperrschicht durch ein oder mehrere stromlose Galvanisierungsverfahren, einen physikalischen Abscheidungsprozess, einen chemischen Dampfabscheidungsprozess oder einen plasmaverstärkten chemischen Dampfabscheidungsprozess gebildet wird.

8. Verfahren nach Anspruch 6, wobei die Sperrschicht Tantalnitrid umfasst.

9. Verfahren nach Anspruch 8, wobei die Sperrschicht von einer Auskleidungsschicht, welche Tantal umfasst, bedeckt ist.

10. Verfahren nach einem der Ansprüche 1-9, wobei das Anlegen das Galvanisieren des Metalls bewirkt, um das Durchgangsloch vollständig zu füllen.

11. Verfahren nach einem der vorherigen Ansprüche, wobei das abgeschiedene Metall entweder im Wesentlichen frei von internen Spannungen ist oder einen internen Spannungsgrad umfasst, der nicht zum Verbiegen des Siliziumsubstrats bei der anschließenden Verarbeitung führt.

12. Verfahren nach einem der vorherigen Ansprüche, wobei die Grundmetallschicht eine Dicke im Bereich von etwa 0,02 µm bis etwa 0,5 µm hat.

13. Verfahren nach einem der vorherigen Ansprüche, wobei die Grundmetallschicht Kupfer umfasst.

14. Verfahren nach einem der vorherigen Ansprüche, wobei im elektrolytischen Bad
die Säure Schwefelsäure mit einer Konzentration im Bereich von etwa 50 bis etwa 350 g/l ist,
die Quelle von Ionen des Metalls Kupfersulfatpentahydrat mit einer Konzentration im Bereich von etwa 20 bis 250 g/l ist,
die Quelle von Eisen (II)- und/oder Eisen (III)-Ionen Eisen (II)-Sulfatheptahydrat und/oder Eisen (III)-Sulfatnonahydrat bei einer Konzentration im Bereich von etwa 1 bis etwa 120 g/l ist und
das mindestens eine Additiv eine oder mehrere polymere sauerstoffhaltige Verbindungen, eine organische Schwefelverbindung, eine Thioharnstoffverbindung und eine polymere Phenazonverbindung umfasst.

15. Verfahren nach einem der vorherigen Ansprüche, wobei die elektrische Spannung in einem Impulsstrom oder in einer Impulsspannung angelegt wird.

16. Verfahren nach Anspruch 15, wobei die elektrische Spannung in einer umgekehrten Impulsspannung mit bipolaren Impulsen angelegt wird.

17. Verfahren nach einem der vorherigen Ansprüche, wobei ein oder mehrere des mindestens einen Additivs eine wesentliche Zersetzung im elektrolytischen Bad bei der ersten Temperatur erfährt, sich aber bei der zweiten Temperatur im Wesentlichen nicht zersetzt.

## Revendications

1. Procédé d'électrodéposition d'un métal dans un passage ménagé dans un substrat en silicium en vue de former un passage (TSV) à travers le silicium, le procédé comportant les étapes qui consistent à :
prévoir un substrat en silicium contenant au moins un passage, le passage comprenant une surface intérieure dont la dimension de largeur intérieure est comprise dans la plage d'environ 1 micromètre à environ 30 micromètres, dont la profondeur est d'environ 5 micromètres à environ 450 micromètres et dont le rapport profondeur-largeur est d'au moins 3:1, le passage comprenant en outre une couche de métal de base qui couvre la surface intérieure, l'épaisseur du métal de base étant suffisante pour obtenir la conductivité nécessaire pour l'électrodéposition ultérieure du métal,
prévoir un bain d'électrolyse dans un système de placage électrolytique de métal, la couche de métal de base étant raccordée comme cathode,
le système comprenant en outre :
un support adapté pour tenir le substrat en silicium et pour chauffer le substrat en silicium de manière uniforme à une première température,
un dispositif de contrôle de température qui maintient la température du bain électrolytique à une deuxième température, le dispositif de contrôle de température comprenant une unité de refroidissement,
une anode insoluble dimensionnellement stable et une source métallique du métal, le bain d'électrolyse comprenant un acide, une source d'ions du métal, une source d'ions ferreux et/ou d'ions ferriques et au moins un additif qui contrôle les propriétés physicomécaniques du métal déposé et
appliquer une tension électrique entre l'anode insoluble dimensionnellement stable et la couche de métal de base de telle sorte qu'un courant s'écoule entre elles dans le bain pendant une durée suffisante pour électrodéposer le métal sur la couche de métal de base de manière à former un TSV, un système redox Fe⁺²/Fe⁺³ étant établi dans le bain de manière à fournir des ions supplémentaires de métal à électrodéposer en dissolvant les ions métalliques de la source métallique, la première température étant maintenue dans une plage comprise entre environ 30°C à environ 60°C et la deuxième température étant maintenue par l'unité de refroidissement à une température (a) d'au moins 5°C plus basse que la première température et (b) comprise dans une plage s'étendant entre environ 15°C et environ 35°C.

2. Procédé selon la revendication 1, dans lequel le métal est le cuivre.

3. Procédé selon l'une quelconque des revendications précédentes, dans lequel la surface intérieure est recouverte d'une couche de matériau diélectrique et la couche de métal de base couvre la couche de matériau diélectrique.

4. Procédé selon l'une quelconque des revendications précédentes, dans lequel la surface intérieure est recouverte d'une couche de matériau diélectrique, la couche de matériau diélectrique étant couverte par une couche de barrière et la couche de métal de base recouvrant la couche de barrière.

5. Procédé selon la revendication 3 ou la revendication 4, dans lequel la couche diélectrique contient du dioxyde de silicium.

6. Procédé selon la revendication 1, dans lequel une couche de barrière est formée sur la surface intérieure.

7. Procédé selon la revendication 4 ou la revendication 6, dans lequel la couche de métal de base est formée sur la couche de barrière par une ou plusieurs opérations de placage non électrolytique, une opération de dépôt physique, une opération de dépôt chimique de vapeur ou une opération de dépôt chimique de vapeur renforcée par plasma.

8. Procédé selon la revendication 6, dans lequel la couche de barrière contient du nitrure de tantale.

9. Procédé selon la revendication 8, dans lequel la couche de barrière est couverte par une couche de garniture contenant du tantale.

10. Procédé selon l'une quelconque des revendications 1 à 9, dans lequel l'application permet d'électrodéposer le métal de manière à remplir complètement le passage.

11. Procédé selon l'une quelconque des revendications précédentes, dans lequel le métal déposé est essentiellement exempt de contraintes internes ou présente un niveau de contraintes internes qui n'entraîne pas une flexion du substrat de silicium lors de la poursuite de son traitement.

12. Procédé selon l'une quelconque des revendications précédentes, dans lequel la couche de métal de base présente une épaisseur comprise dans la plage d'environ 0,02 µm à environ 0,5 µm.

13. Procédé selon l'une quelconque des revendications précédentes, dans lequel la couche de métal de base contient du cuivre.

14. Procédé selon l'une quelconque des revendications précédentes, dans lequel, dans le bain électrolytique,
l'acide est l'acide sulfurique à une concentration comprise dans la plage d'environ 50 à environ 350 g/l,
la source d'ions de métal est le sulfate de cuivre pentahydraté à une concentration comprise dans la plage d'environ 20 à environ 250 g/l,
la source d'ions ferreux et/ou la source d'ions ferriques est le sulfate ferreux heptahydraté et/ou le sulfate ferrique nonahydraté à une concentration comprise dans la plage d'environ 1 à environ 120 g/l et
le ou les additifs comprennent un ou plusieurs d'un composé polymère contenant de l'oxygène, un composé organique du soufre, un composé de thiourée ou un composé polymère de phénasonium.

15. Procédé selon l'une quelconque des revendications précédentes, dans lequel la tension électrique est appliquée en courant pulsé ou en tension pulsée.

16. Procédé selon la revendication 15, dans lequel la tension électrique est appliquée sous la forme de pulsations inversées bipolaires.

17. Procédé selon l'une quelconque des revendications précédentes, dans lequel un ou plusieurs desdits additifs subit une décomposition essentielle dans le bain électrolytique à la première température mais ne se décompose essentiellement pas à la deuxième température.
